(19) Europäisches Patentamt
European Patent Office
Office européen des brevets

(11) EP 1 510 865 A2

(12) # EUROPEAN PATENT APPLICATION

(43) Date of publication:
**02.03.2005 Bulletin 2005/09**

(51) Int Cl.[7]: **G03F 7/029**

(21) Application number: **04020028.9**

(22) Date of filing: **24.08.2004**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **28.08.2003 JP 2003304490**
**24.09.2003 JP 2003331593**
**15.07.2004 JP 2004208186**

(71) Applicant: **Fuji Photo Film Co., Ltd.**
**Kanagawa-ken (JP)**

(72) Inventors:
- **Kondo, Shunichi Fuji Photo Film Co., Ltd. Haibara-gun Shizuoka (JP)**
- **Higashi, Tatsuji Fuji Photo Film Co., Ltd. Haibara-gun Shizuoka (JP)**

(74) Representative: **HOFFMANN - EITLE**
**Patent- und Rechtsanwälte**
**Arabellastrasse 4**
**81925 München (DE)**

(54) **Photopolymerizable composition and image recording material**

(57) A photopolymerizable composition contains:

(A) addition polymerizable compound having an ethylenically unsaturated double bond;
(B) one of an alkali-soluble binder and an alkali swelling binder,
(C) a titanocene compound, and
(D) a triazine compound represented by the following fomula (I):

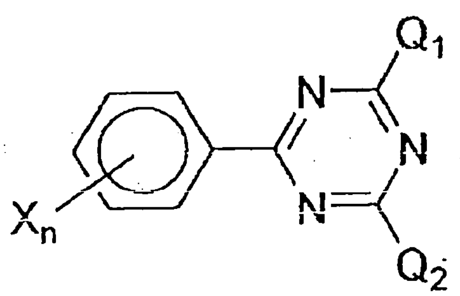

(I)

wherein $Q_1$ and $Q_2$ each independently represents a halomethyl group; X represents an electron withdrawing substituent having a Hammett's σ value of from 0 to +0.8, exclusive of a COOH group; and n represents an integer of from 0 to 5.

EP 1 510 865 A2

## Description

## BACKGROUND OF THE INVENTION

### TECHNICAL FIELD OF THE INVENTION

The present invention relates to a photopolymerizable composition and an image recording material. In particular, the invention relates to a photopolymerizable composition having high sensitivity and excellent printing resistance and an image recording material.

### DESCRIPTION OF THE RELATED ART

In image recording materials such as negative working photosensitive lithographic printing plates, in general, image formation is carried out by a process of coating a photosensitive composition on a support such as a roughed aluminum plate, exposing a desired image, polymerizing or crosslinking an image portion (light-irradiated portion), thereby insolubilizing it in a developing solution, and eluting a non-image portion with the developing solution. As photosensitive compositions to be used for such a purpose, photopolymerizable compositions have hitherto been well known, a part of which is already put into practical use. Also, in recent high-speed photopolymers which adopt a photoinitiation system technology which is highly sensitive to a visible light, high sensitization advances to regions employed for direct plate making by visible lasers, and so-called CTP plates become widespread.

However, in all of these photopolymerizable compositions, when used as a photosensitive layer (image recording layer) of a lithographic printing plate, there are encountered such problems that it is necessary to exchange a plate on the way of printing due to abrasion of the plate and that an image portion is deteriorated by a chemical to be used in wiping off stains on the plate surface. Therefore, improvements have been demanded.

For the sake of improving these problems, JP-B-3-63740 and JP-B-6-10535 disclose the use of a binder having a crosslinking group such as an allyl group and a vinyl group, and JP-A-11-352691 discloses the use of a polyurethane binder.

These binders solves the foregoing problems, are effective as a measure for achieving high sensitization, and are put into practical use for lithographic printing plates employing photopolymerization. However, higher sensitization and higher printing resistance have been demanded.

On the other hand, Japanese Patent No. 3,187,569 discloses a photopolymerizable composition containing as a photopolymerization initiator a combination of a titanocene compound, an acridine compound, and a triazine compound having a specific structure. Also, JP-A-2001-147526 discloses a photosensitive composition using as a photopolymerization initiator a combination of a titanocene compound and a halomethyl triazine compound having a phenyl group substituted with an alkoxy group. However, these compositions did not have a satisfactory sensitivity yet. Further, JP-A-2001-100411 discloses a photosensitive composition using as a photopolymerization initiator a combination of a titanocene compound and a halomethyl triazine compound having a phenyl group substituted with a hydroxyl group or a carboxyl group. However, this composition involved such a problem that not only the sensitivity is not satisfactory, but also the hydrophilicity is so high that deposition of crystals in the photosensitive layer and damage in a developing solution increase, resulting in deterioration of the printing resistance. Moreover, JP-A-2001-66773 discloses a photosensitive composition using as a photopolymerization initiator a combination of a titanocene compound and a halomethyl oxadiazole compound. However, this composition did not have a satisfactory performance yet.

## SUMMARY OF THE INVENTION

Accordingly, an object of the invention is to provide a photopolymerizable composition having high sensitivity and excellent stability with time. In more detail, an object of the invention is to provide a photopolymerizable composition for lithographic printing plate having high sensitivity and excellent printing resistance and an image recording material.

In order to solve the foregoing problems, the present inventor made extensive and intensive investigations. As a result, it has been found that by combining a titanocene compound with a specific triazine compound or a trihalomethyl group-containing compound having specific physical properties as a polymerization initiator, a photopolymerizable composition having excellent sensitivity and printing resistance and an image recording material provided with an image recording layer containing this composition are obtained, leading to accomplishment of the invention.

Specifically, the invention is as follows.

(1). A photopolymerizable composition containing:

(A) addition polymerizable compound having an ethylenically unsaturated double bond;

(B) one of an alkali-soluble binder and an alkali swelling binder,
(C) a titanocene compound, and
(D) a triazine compound represented by the following fomula (I):

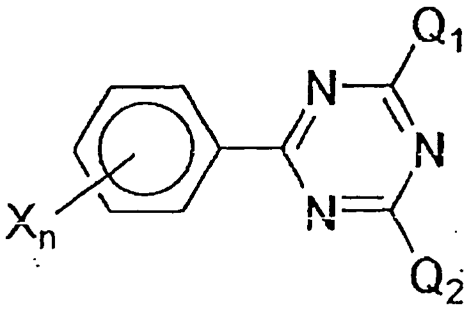

(I)

wherein $Q_1$ and $Q_2$ each independently represents a halomethyl group; X represents an electron withdrawing substituent having a Hammett's σ value of from 0 to +0.8, exclusive of a COOH group; and n represents an integer of from 0 to 5.

(2). A photopolymerizable composition containing:

(A) addition polymerizable compound having an ethylenically unsaturated double bond;
(B) one of an aqueous alkali-soluble binder and a alkali swelling binder,
(C) a titanocene compound, and
(D2) a compound containing a trihalomethyl group having a molar extinction coefficient of not more than 1,000 at a wavelength of laser to be exposed.

(3). The photopolymerizable composition described in (2), wherein the compound (D2) is a compound represented by any one of the following fomulae (1) to (3):

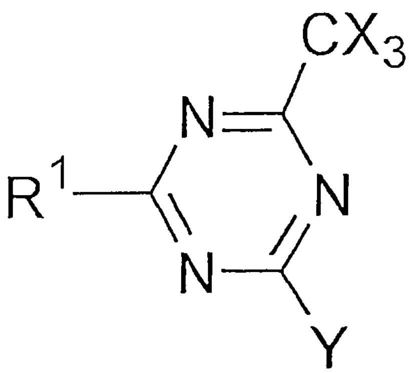

(1)

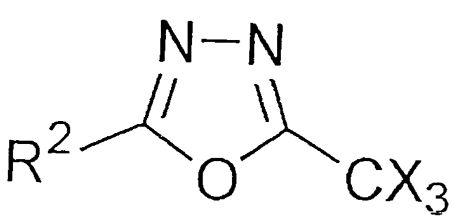

(2)

$$R^3\text{-}CX_3 \quad (3)$$

wherein X represents a halogen atom; Y represents $-CX_3$, $-NH_2$, $-NHR$, $-NR_2$, or -OR; R and $R^1$ each independently represents $-CX_3$, an alkyl group, an aryl group, an alkenyl group, or a heterocyclic group; $R^2$ represents an alkyl group, an aryl group, an alkenyl group, or a heterocyclic group; and $R^3$ represents $R\text{-}SO_2$- an alkyl group, an aryl group, an alkenyl group, or a heterocyclic group.

(4). The photopolymerizable composition described in any one of (1) to (3), which further comprising (E) a sensitizing dye.

(5). The photopolymerizable composition described in (4), wherein the sensitizing dye (E) has an absorption maximum wavelength at a range of from 330 to 430 nm.

(6). The photopolymerizable composition described in any one of (1) to (5), wherein the binder (B) is one of a (meth)acrylic binder and a polyurethane based binder.

(7). An image recording material containing a support and an image recording layer on the support,

wherein the image recording material comprises the photopolymerizable composition described in any one of (1) to (6) .

According to the invention, a lithographic printing plate having high sensitivity and high printing resistance is obtained.

## DETAILED DESCRIPTION OF THE INVENTION

The invention will be described below in detail.

<Photopolymerizable composition>

The photopolymerizable composition of the invention contains an ethylenically unsaturated double bond-containing addition polymerizable compound (hereinafter sometimes abbreviated as "ethylenically unsaturated bond-containing compound"), an alkali-soluble or swelling binder, and a photoinitiation system as essential components and can jointly use a variety of compounds such as coloring agents, plasticizers, and heat polymerization inhibitors as the need arises.

(Ethylenically unsaturated bond-containing compound)

The "ethylenically unsaturated bond-containing compound" as referred to herein means a compound having an ethylenically unsaturated double bond, which causes addition polymerization, crosslinking and curing by the action of a photopolymerization initiator when the photopolymerizable composition is irradiated with active rays. The ethylenically unsaturated double bond-containing compound can be arbitrarily chosen from compounds having at least one, and preferably two or more ethylenically unsaturated bonds. For example, it includes ones having a chemical morphology, such as monomers, prepolymers (that is, dimers, trimers, and oligomers), and mixtures or copolymers thereof.

Examples of monomers and copolymers thereof include esters between an unsaturated carboxylic acid (for example, acrylic acid, methacrylic acid, itaconic acid, crotonic acid, isocrotonic acid, and maleic acid) and an aliphatic polyhydric alcohol and amides between an unsaturated carboxylic acid and an aliphatic polyhydric amine compound.

Specific examples of monomers of esters between an aliphatic polyhydric alcohol and an unsaturated carboxylic acid are given below. That is, examples of acrylic esters include ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol pentaacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, and polyester acrylate oligomers.

Examples of methacrylic esters include tetramethylene glycol dimethacrylate, triethylene glycol dimethacrylate, neopentyl glycol dimethacrylate, trimethylolpropane trimethacrylate, trimethoylethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis[p-(3-methacryloxy-2-hydroxypropoxy)phenyl]-dimethylmethane, and bis[p-(methacryloxyethoxy)phenyl]dimethylmethane.

Examples of itaconic esters include ethylene glycol diitaconate, propylene glycol diitaconate, 1,5-butanediol diitaconate, 1,4-butanediol diitaconate, tetramethylene glycol diitaconate, pentaerythritol diitaconate, and sorbitol tetraitaconate.

Examples of crotonic esters include ethylene glycol dicrotonate, tetramethylene glycol dicrotonate, pentaerythritol dicrotonate, and sorbitol tetradicrotonate.

Examples of isocrotonic esters include ethylene glycol diisocrotonate, pentaerythritol diisocrotonate, and sorbitol tetraisocrotonate.

Examples of maleic esters include ethylene glycol dimaleate, triethylene glycol dimaleate, pentaerythritol dimaleate, and sorbitol tetramaleate. Further, mixtures of the foregoing ester monomers can be enumerated.

Also, specific examples of monomers of amides between an aliphatic polyhydric amine compound and an unsaturated carboxylic acid include methylene bis-acrylamide, methylene bis-methacrylamide, 1,6-hexamethylene bis-acrylamide, 1,6-hexamethylene bis-methacrylamide, diethylenetriamine tris-acrylamide, xylylene bis-acrylamide, and xylylene bis-methacrylamide.

Other examples include vinylurethane compounds containing two or more polymerizable vinyl groups in one molecule, resulting from addition of a hydroxyl group-containing vinyl monomer represented by the following fomula (A) to a polyisocyanate compound having two or more isocyanate groups in one molecule, as described in JP-B-48-41708.

$$CH_2=C(R)COOCH_2CH(R')OH \quad (A)$$

In the formula, R and R' each independently represents H or $CH_3$.

Also, polyfunctional acrylates or methacrylates such as urethane acrylates described in JP-A-51-37193 and JP-B-2-32293; polyester acrylates described in JP-A-48-64183, JP-B-49-43191, and JP-B-52-30490; and epoxy acrylates resulting from reaction between an epoxy resin and (meth)acrylic acid can be enumerated. Further, ones introduced as a photocurable monomer or oligomer in *Nippon Setchaku Kyoukaishi,* Vol. 20, No. 7, pp.300-308 (1984) can be used.

Specific examples include NK OLIGO U-4HA, NK OLIGO U-4H, NK OLIGO U-6HA, NK OLIGO U-108A, NK OLIGO U-1084A, NK OLIGO U-200AX, NK OLIGO U-122A, NK OLIGO U-340A, NK OLIGO UA-324A, and NK OLIGO UA-100 (all of which are manufactured by Shin-Nakamura Chemical Co., Ltd.); UA-306H, AI-600, UA-101T, UA-101I, UA-306T, and UA-306I (all of which are manufactured by Kyoeisha Chemical Co., Ltd.); and ART RESIN UN-9200A, ART RESIN UN-3320HA, ART RESIN UN-3320HB, ART RESIN UN-3320HC, ART RESIN SH-380G, ART RESIN SH-500, and ART RESIN SH-9832 (all of which are manufactured by Negami Chemical Industrial Co., Ltd.).

In the invention, the amount of the ethylenically unsaturated bond-containing compound to be used is in the range of from 10 to 80 % by weight, and more preferably from 30 to 70 % by weight based on the whole of the photopolymerizable composition.

(Alkali-soluble or swelling binder)

The alkali-soluble or swelling binder which is used in the polymerizable composition of the invention is required not only to function as a film forming agent and but also to be dissolved in an alkaline developing solution. Accordingly, organic high-molecular polymers that are soluble or swelling in an alkali are used. With respect to the organic high-molecular polymers, for example, when a water-soluble organic high-molecular polymer is used, it is possible to perform water development. Examples of such organic high-molecular polymers include addition polymers having a carboxyl group in the side chain thereof, such as ones described in JP-A-59-44615, JP-B-54-34327, JP-B-58-12577, JP-B-54-25957, JP-A-54-92723, JP-A-59-53836, and JP-A-59-71048, that is, methacrylic acid copolymers, acrylic acid copolymers, itaconic acid copolymers, crotonic acid copolymers, maleic acid copolymers, and partially esterified maleic acid copolymers.

Also, acidic cellulose derivatives having a carboxyl group in the side chain thereof are enumerated, too. Besides, ones resulting from addition of a cyclic acid anhydride to a hydroxyl group-containing addition polymer, and the like are useful. Of these, [benzyl (meth)acrylate/(meth)acrylic acid/optionally, other addition polymerizable vinyl monomer] copolymers and [allyl (meth)acrylate/(meth)acrylic acid/optionally, other addition polymerizable vinyl monomer] copolymers are especially suitable. Besides, polyvinylpyrrolidone and polyethylene oxide are useful as the water-soluble high-molecular polymer. Also, for the purpose of enhancing the strength of a cured film, alcohol-soluble polyamides and polyether between 2,2-bis(4-hydroxyphenyl)-propane and epichlorohydrin are useful. Also, polyurethane resins described in JP-B-7-120040, JP-B-7-120041, JP-B-7-120042, JP-B-8-12424, JP-A-63-287944, JP-A-63-287947, JP-A-1-271741, and JP-A-11-352691 are useful for the applications of the invention.

In the invention, (meth) acrylic binders and polyurethane based binders are especially preferable as the alkali-soluble or swelling binder.

Above all, alkali-soluble polyurethane based resins containing a carboxyl group in the molecule are preferable.

The polyurethane based resin that is preferably used as the binder in the photosensitive layer of the invention is not particularly limited, and examples thereof include:

(i) polyurethane resins comprising a structural unit represented by a reaction product of at least one diisocyanate compound represented by the following formula (1') and at least one diol compound represented by the following formula (1") as a basic skeleton; and

(ii) polyurethane resins comprising the foregoing structural unit as a basic skeleton and being produced from reaction between an isocyanate group derived from a diisocyanate compound as a polymerization terminal and a monoalcohol compound having an ethylenically unsaturated bond which is addition polymerizable, or a monoamine compound having an addition polymerizable ethylenically unsaturated bond.

$$OCN\text{-}X^0\text{-}NCO \qquad (1')$$

$$HO\text{-}Y^0\text{-}OH \qquad (1")$$

In the formulae, $X^0$ and $Y^0$ each represents a divalent organic residual group.

The polyurethane resin that is preferable as the high-molecular binder to be used in the composition of the invention is a polyurethane resin having 0.4 meg/g or more of a carboxyl group. The polyurethane resin to be suitably used is a polyurethane resin comprising as a basic skeleton a structural unit represented by a reaction product of a diisocyanate compound represented by the following formula (6) and at least one of diol compounds represented by the following formulae (7), (8) and (9) and/or a structural unit derived from a compound resulting from ring opening of a tetracarboxylic acid dianhydride with a diol compound.

$$OCN—L_B—NCO \qquad (6)$$

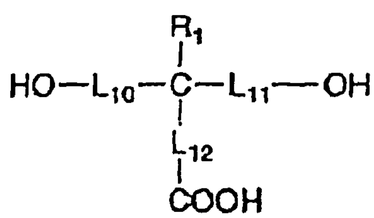

(7)

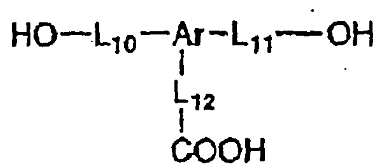

(8)

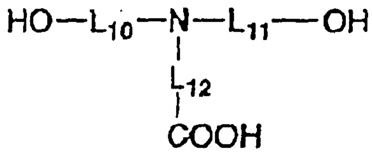
(9)

In the formulae, $L_8$ represents an optionally substituted divalent aliphatic or aromatic hydrocarbon group. If desired, $L_8$ may contain other functional group which does not react with the isocyanate group, such as an ester group, a urethane group, an amide group, and a ureido group.

$R_1$ represents a hydrogen atom, an alkyl group, an aralkyl group, an aryl group, an alkoxy group, or an aryloxy group, each of which may have a substituent (for example, cyano, nitro, a halogen atom (for example, -F, -Cl, -Br, and -I), $-CONH_2$, $-COOR_{113}$, $-OR_{113}$, $-NHCONHR_{113}$, $-NHCOOR_{113}$, $-NHCOR_{113}$, and $-OCONHR_{113}$ (wherein $R_{113}$ represents an alkyl group having from 1 to 10 carbon atoms or an aralkyl group having from 7 to 15 carbon atoms) ) ; and preferably a hydrogen atom, an alkyl group having from 1 to 8 carbon atoms, or an aryl group having from 6 to 15 carbon atoms. $L_{10}$, $L_{11}$, and $L_{12}$ may be the same or different and each represents a single bond or a divalent aliphatic or aromatic hydrocarbon group which may have a substituent (for example, an alkyl group, an aralkyl group, an aryl group, an alkoxy group, and a halogeno group); preferably an alkylene group having from 1 to 20 carbon atoms or an arylene group having from 6 to 15 carbon atoms; and more preferably an alkylene group having from 1 to 8 carbon atoms. Also, if desired, $L_{10}$, $L_{11}$, and $L_{12}$ may each contain other functional group which does not react with the isocyanate group, such as a carbonyl group, an ester group, a urethane group, an amide group, a ureido group, and an ether group. Incidentally, two or three of $L_{10}$, $L_{11}$, and $L_{12}$ may be taken together to form a ring.

Ar represents an optionally substituted trivalent aromatic hydrocarbon group, and preferably an aromatic group having from 6 to 15 carbon atoms.

The polyurethane resin of the invention preferably has a weight average molecular weight of 1,000 or more, and more preferably in the range of from 5,000 to 500,000.

With respect to specific examples of the diisocyanate compound represented by the foregoing formula (6) and the diol compounds represented by the foregoing formulae (7), (8) and (9) and preferred specific examples of the foregoing polyurethane resin (i) and so on, ones described in JP-A-11-352691 (paragraph Nos. [0021] to [0149]) are enumerated, but it should not be construed that the invention is limited thereto.

Also, with respect to preferred specific examples of the polyurethane resin (ii), ones described in JP-A-2001-109139 (paragraph Nos. [0085] to [0088]) are enumerated, but it should not be construed that the invention is limited thereto.

The polyurethane resin (ii) to be used in the invention is preferably a polyurethane resin having a structure represented by a reaction product with at least one kind of a polyether diol compound, a polyester diol compound, and a polycarbonate diol compound.

The high-molecular binder according to the invention may be used singly or in admixture of two or more thereof.

In these organic high-molecular polymers, it is possible to enhance the strength of a cured film by introducing a radical reactive group into the side chain. Examples of functional groups capable of undergoing addition polymerization reaction include an ethylenically unsaturated bonding group, an amino group, and an epoxy group; examples of functional groups capable of becoming a radical upon irradiation with light include a mercapto group, a thiol group, a halogen atom, a triazine structure, and an onium salt structure; and examples of polar groups include a carboxyl group and an imido group. As the foregoing functional group capable of undergoing addition polymerization reaction, ethylenically unsaturated bonding groups such as an acrylic group, a methacrylic group, an allyl group, and a styryl group are especially preferable. Also, functional groups selected from an amino group, a hydroxyl group, a phosphonic acid group, a phosphoric acid group, a carbamoyl group, an isocyanate group, a ureido group, a ureylene group, a sulfonic acid group, and an ammonio group are useful.

For the purpose of keeping developability of the image recording layer, it is preferable that the high-molecular binder has adequate molecular weight and acid value, and high-molecular polymers having a weight average molecular weight of from 5,000 to 300,000 and an acid value of from 20 to 200 are effectively used. Such a high-molecular binder can be mixed in an arbitrary amount in the composition of the invention. Especially, when the amount of the high-molecular binder is not more than 90 % by weight, good results are brought in view of the formed image strength, etc. The amount of the high-molecular binder is preferably from 10 to 90 % by weight, and more preferably from 30 to 80 % by weight. Also, a ratio of the photopolymerizable ethylenically unsaturated bond-containing compound to the high-molecular binder is preferably in the range of from 1/9 to 9/1, more preferably from 2/8 to 8/2, and further preferably from 3/7 to 7/3 in terms of a weight ratio.

(Photoinitiation system)

The photoinitiation system of the invention contains as a polymerization initiator at least a titanocene compound and a triazine compound represented by the foregoing fomula (I) or a compound having a trihalomethyl group having a molar extinction coefficient of not more than 1, 000 at a wavelength of laser to be exposed, and preferably further contains a sensitizing dye. The respective constitutional components will be described below in detail.

<Titanocene compound>

As the titanocene compound which can be used in the photopolymerizable composition of the invention, a variety of titanocene compounds can be used, and for example, various titanocene compounds described in JP-A-59-152396 and JP-A-61-151197 can be adequately chosen and used. Specific examples thereof include dicyclopentadienyl-Ti-dichloride, dicyclopentadienyl-Ti-bisphenyl, dicyclopentadienyl-Ti-bis-2,3,4,5,6-pentafluorophen-l-yl, dicyclopentadienyl-Ti-bis-2,3,5,6-tetrafluorophen-1-yl, dicyclopentadienyl-Ti-bis-2,4,6-trifluorophen-1-yl, dicyclopentadienyl-Ti-bis-2,6-difluorophen-1-yl, dicyclopentadienyl-Ti-bis-2,4-difluorophen-1-yl, dimethylcyclopentadienyl-Ti-bis-2,3,4,5,6-pentafluorophen-1-yl, dimethylcyclopentadienyl-Ti-2,6-difluorophen-1-yl, and dicyclopentadienyl-Ti-bis-2,6-difluoro-3-(pyl-1-yl)phen-1-yl. Further, it is known that a photoinitiation ability can be more enhanced by further adding a hydrogen providing compound [for example, thiol compounds (such as 2-mercaptobenzthiazole, 2-mercaptobenzimidazole, and 2-mercaptobenzoxazole) and amine compounds (such as N-phenylglycine and N,N-dialkylamino aromatic alkyl esters) ] to the foregoing photoinitiator as the need arises.

<Halomethyl triazine compound>

A first embodiment of the invention is characterized in that a halomethyl triazine compound represented by the following fomula (I) is used jointly with the foregoing titanocene compound as a photopolymerization initiator.

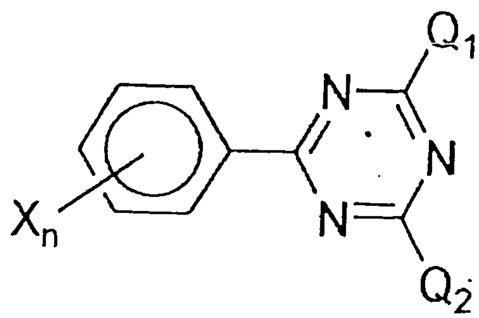

(I)

In the formula, $Q_1$ and $Q_2$ each independently represents a halomethyl group; X represents an electron withdrawing group having a Hammett's σ value in the range of from 0 to +0.8, exclusive of a COOH group; and n represents an integer of from 0 to 5.

Incidentally, in the invention, the definition of Hammett's σ values follows *Rates and Equilibria of Organic Reactions,* written by J.E. Leffler and translated by Yuho Tsuno (published by Hirokawa Publishing Co., Ltd., Tokyo (1968)).

In the triazine compound represented by the fomula (I), which is used in the invention, specific examples of the substituent X having a Hammett's σ value in the range of from 0 to +0.8 include a phenyl group, an electron withdrawing group-substituted phenyl group, a naphthyl group, an electron withdrawing group-substituted naphthyl group, a trifluoromethyl group, a cyano group, an acetyl group, an ethoxycarbonyl group, a $-PO_3H$ group, an alkyl-substituted phosphonyl group, a thiocyano group, a methylsulfonyl group, an ethylsulfonyl group, a dimethylsulfonyl group, a fluorine atom, a chlorine atom, a bromine atom, an iodine atom, and an iodyl group.

Of these, a hydrogen atom, a chlorine atom, a bromine atom, a cyano group, a trifluoromethyl group, an acetyl group, a phenyl group, and an electron withdrawing group-substituted phenyl group are preferable.

Specific compounds represented by the fomula (I) will be given below, but it should not be construed that the invention is limited thereto.

(I)-1

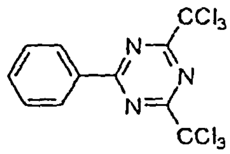

(I)-2

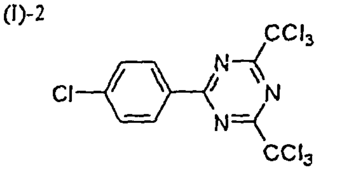

(I)-3

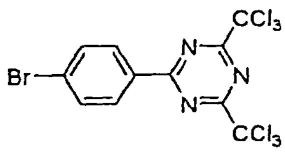

(I)-4

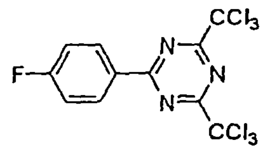

(I)-5

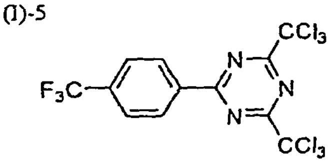

(I)-6

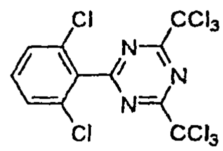

(I)-7

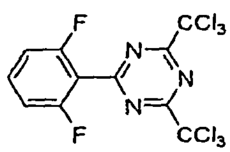

(I)-8

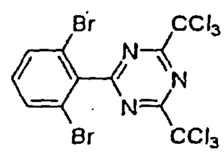

(I)-9

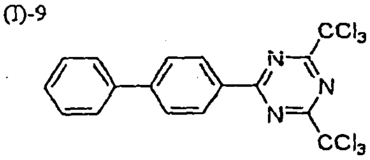

(I)-10

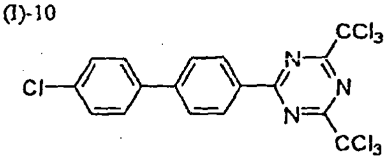

(I)-11

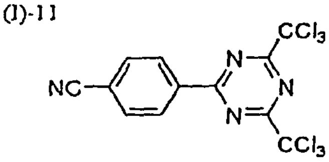

(I)-12

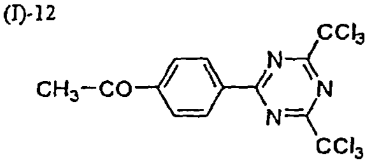

(I)-13

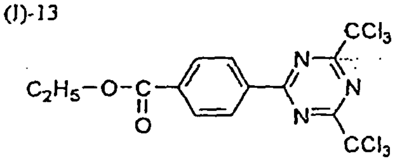

(I)-14

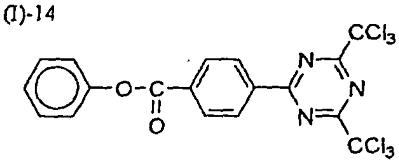

(I)-15

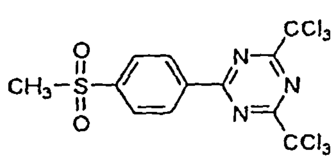

(I)-16

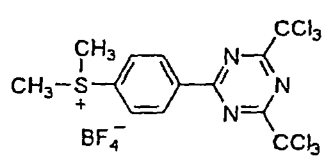

(I)-17

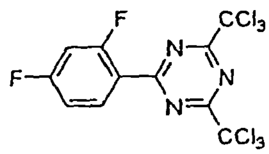

(I)-18

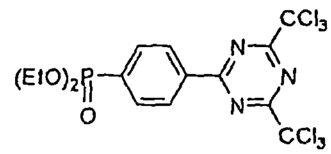

<Trihalomethyl group-containing compound>

A second embodiment of the invention is characterized in that a trihalomethyl group-containing compound having a molar extinction coefficient of not more than 1, 000 at a wavelength of laser to be exposed (hereinafter sometimes abbreviated as "trihalomethyl group-containing compound") is used jointly with the foregoing titanocene compound as a photopolymerization initiator. It is preferred that the wavelength of laser to be exposed is 350 to 450nm. However, it is not to be construed as limitative of the invention.

As a preferred structure of the trihalomethyl group-containing compound, compounds represented by any one of the following fomulae (1) to (3) are enumerated.

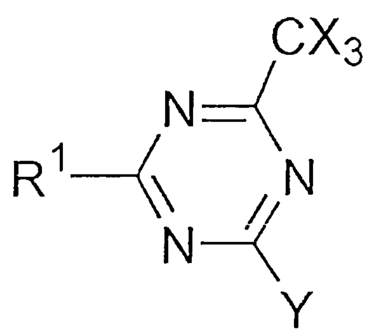

(1)

In the formula (1), X represents a halogen atom; Y represents $-CX_3$, $-NH_2$, -NHR, $-NR_2$, or -OR; and R and $R^1$ each independently represents $-CX_3$, an alkyl group, an aryl group, an alkenyl group, or a heterocyclic group.

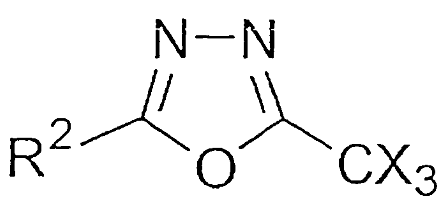

(2)

In the formula (2), X represents a halogen atom; and $R^2$ represents an alkyl group, an aryl group, an alkenyl group, or a heterocyclic group.

$$R^3\text{-}CX_3 \qquad (3)$$

In the formula (3), X represents a halogen atom; $R^3$ represents $R\text{-}SO_2\text{-}$ an alkyl group, an aryl group, an alkenyl group, or a heterocyclic group; and R represents $-CX_3$, an alkyl group, an aryl group, an alkenyl group, or a heterocyclic group.

In the foregoing, as the halogen atom represented by X, a fluorine atom, a chlorine atom, and a bromine atom are preferable. The alkyl group represented by R, $R^1$, $R^2$, and $R^3$, is preferably one having from 1 to 10 carbon atoms; the aryl group is preferably a phenyl group or a naphthyl group; the alkenyl group is preferably one having from 1 to

10 carbon atoms; and the heterocyclic group is preferably a 5-membered to 7-membered ring having an oxygen or nitrogen atom and may form a fused ring.

Also, the alkyl group, the aryl group, the alkenyl group, and the heterocyclic group may each have a substituent. Examples of the substituent include a cyano group, an alkyl group having from 1 to 10 carbon atoms, an alkoxy group having from 1 to 10 carbon atoms, and an optionally substituted vinyl group.

Specific examples of the trihalomethyl group-containing compounds represented by the fomulae (1) to (3) will be given below along with their physical properties, but it should not be construed that the invention is limited thereto.

compound1 – 1

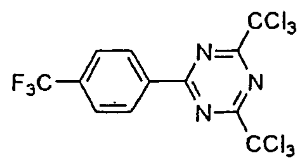

λ max=267nm
λ max ε =17、700
405nm ε =0
Mw=460

compound 1 – 2

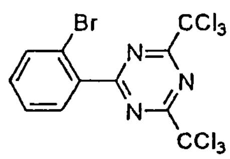

λ max=275nm
λ max ε =13、300
405nm ε =0
Mw=471

compound 1 – 3

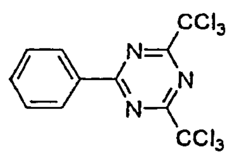

λ max=281nm
λ max ε =19、800
405nm ε =0
Mw=392

compound 1 – 4

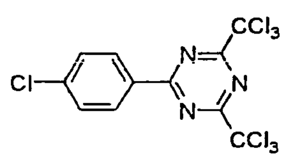

λ max=293nm
λ max ε =23、400
405nm ε =0
Mw=426

compound 1 – 5

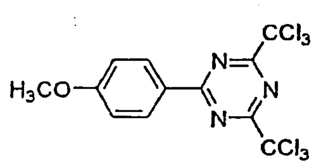

λ max=329nm
λ max ε =26、800
405nm ε =100
Mw=422

compound 1 – 6

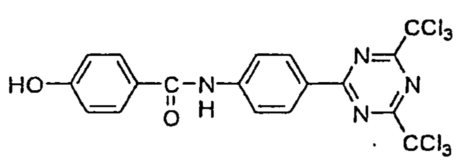

λ max=353nm
λ max ε =42、700
405nm ε =240
Mw=527

compound 1 − 7

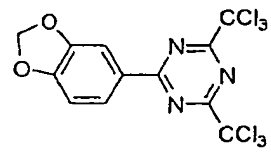

$\lambda$ max=354nm
$\lambda$ max $\varepsilon$ =13、500
405nm $\varepsilon$ =530
Mw=436

compound 1 − 8

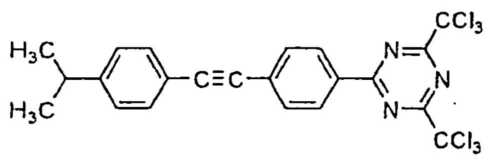

$\lambda$ max=357nm
$\lambda$ max $\varepsilon$ =34、500
405nm $\varepsilon$ =760
Mw=534

compound 2 − 1

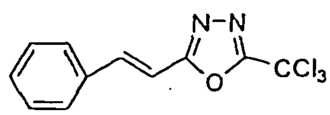

$\lambda$ max=303nm
$\lambda$ max $\varepsilon$ =25、500
405nm $\varepsilon$ =0
Mw=290

compound 2 − 2

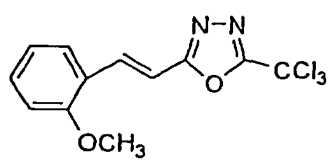

$\lambda$ max=340nm
$\lambda$ max $\varepsilon$ =16、500
405nm $\varepsilon$ =50
Mw=320

compound 2 − 3

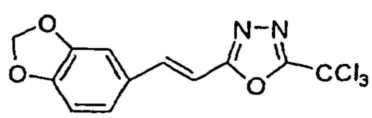

$\lambda$ max=342nm
$\lambda$ max $\varepsilon$ =26、000
405nm $\varepsilon$ =100
Mw=334

compound 2 − 4

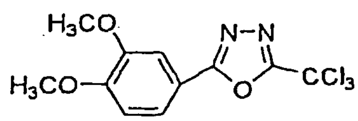

$\lambda$ max=307nm
$\lambda$ max $\varepsilon$ =15、200
405nm $\varepsilon$ =0
Mw=324

compound 2 − 5

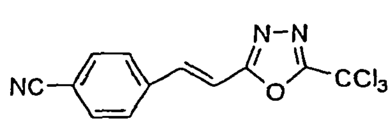

$\lambda$ max=303nm
$\lambda$ max $\varepsilon$ =37、900
405nm $\varepsilon$ =0
Mw=315

compound 2 − 6

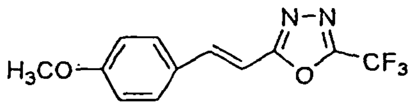

$\lambda$ max=326nm
$\lambda$ max $\varepsilon$ =24, 500
405nm $\varepsilon$ =20
Mw=270

compound 2 − 7

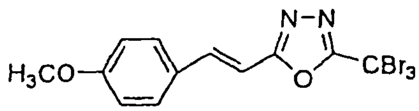

$\lambda$ max=336nm
$\lambda$ max $\varepsilon$ =32, 400
405nm $\varepsilon$ =50
Mw=453

compound 3 − 1

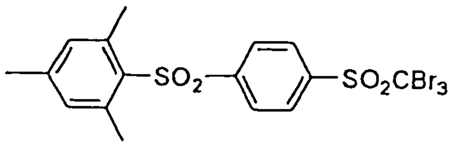

$\lambda$max $\leq$ 300
405nm $\varepsilon$ =0
Mw=575

compound 3 − 2

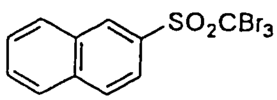

$\lambda$ max=336nm
$\lambda$ max $\varepsilon$ =2100
405nm $\varepsilon$ =0
Mw=443

compound 3 − 3

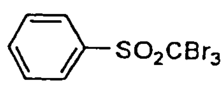

$\lambda$max $\leq$ 300
405nm $\varepsilon$ =0
Mw=393

compound 3 − 4

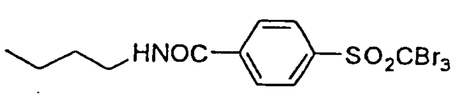

$\lambda$max $\leq$ 300
405nm $\varepsilon$ =0
Mw=492

3-5

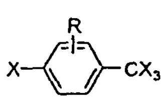

3-6

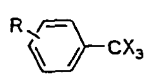

3-7 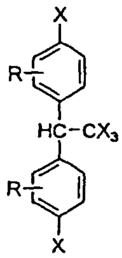

3-8 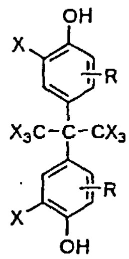

3-9 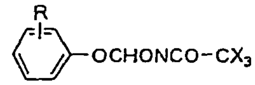

3-10 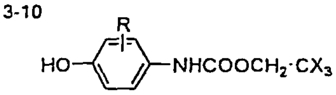

3-11 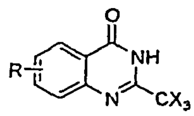

3-12 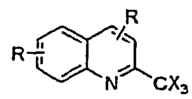

3-13 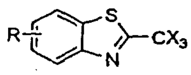

3-14 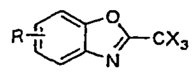

3-15 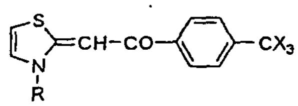

3-16 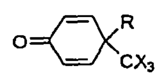

3-17 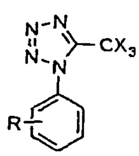

3-18 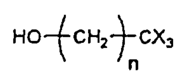

The compounds represented by the foregoing formula (1) can be synthesized by methods described in JP-B-6-42074 and JP-B-6-93117.

Further, auxiliaries such as amine compounds and thiol compounds may be added to the photopolymerization initiator to be used in the invention as the need arises. By adding these hydrogen providing compounds, the photopolymerization initiation ability can be more enhanced.

Amine compounds and amino acids represented by the following fomulae are preferable as the auxiliary.

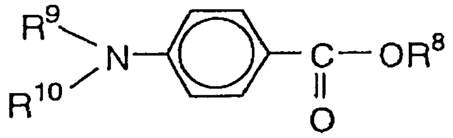

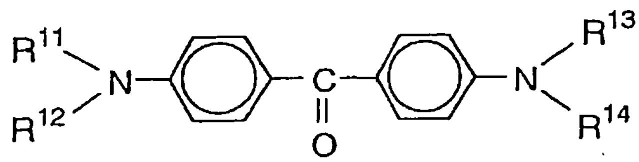

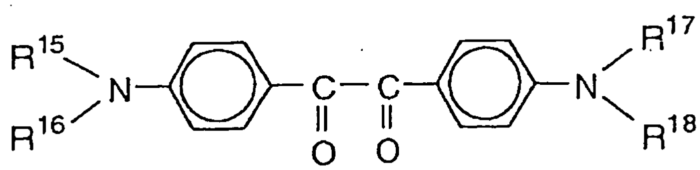

In the formulae, $R^8$ to $R^{18}$ each represents an alkyl group.

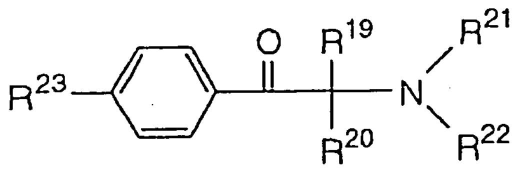

In the formula, $R^{19}$ to $R^{22}$ each independently represents an alkyl group or an alkoxy group; $R^{21}$ and $R^{22}$ may be taken together to form a ring; and $R^{23}$ represents a heterocyclic group or an alkylthio group.

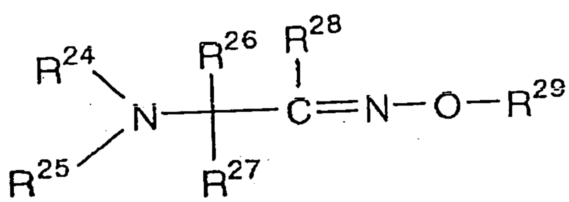

In the formula, $R^{28}$ and $R^{29}$ may be the same or different and each represents an optionally substituted hydrocarbon group which may contain an unsaturated bond or a heterocyclic group.

$R^{26}$ and $R^{27}$ may be the same or different and each represents a hydrogen atom, an optionally substituted hydrocarbon group which may contain an unsaturated bond, a heterocyclic group, a hydroxyl group, a substituted oxy group, a mercapto group, or a substituted thio group. Also, $R^{26}$ and $R^{27}$ each represents an alkylene group having from 2 to 8 carbon atoms, which may be taken together to form a ring and which may contain -O-, $-NR^{24}-$, -O-CO-, -NH-CO-, -S-, and/or $-SO_2-$ in the connecting main chain of the ring.

$R^{24}$ and $R^{25}$ each represents a hydrogen atom, an optionally substituted hydrocarbon group which may contain an unsaturated bond, or a substituted carbonyl group.

Also, there are enumerated dialkyl benzoic acid esters such as ethyl p-diethylaminobenzoate; bisaminobenzophenones such as 4,4'-bis(dimethylamino)benzophenone; and bisaminobenzils such as 4,4'-bis(diethylamino)benzyl.

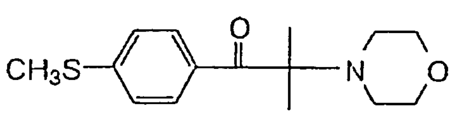

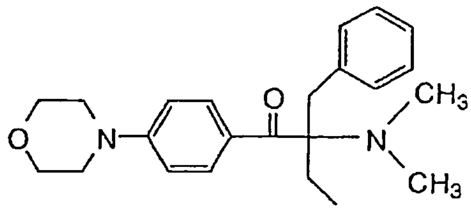

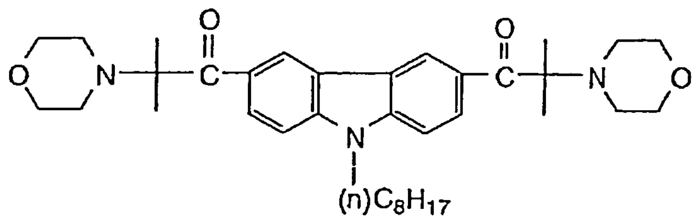

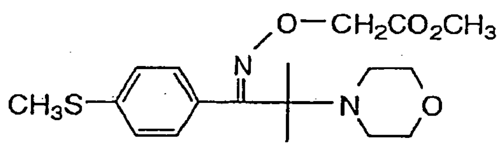

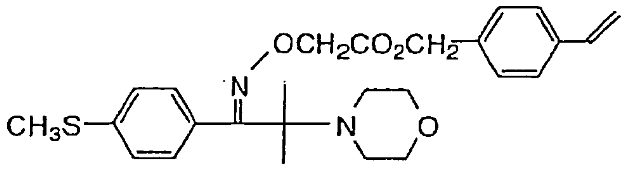

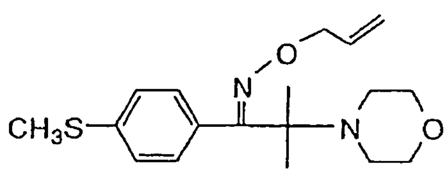

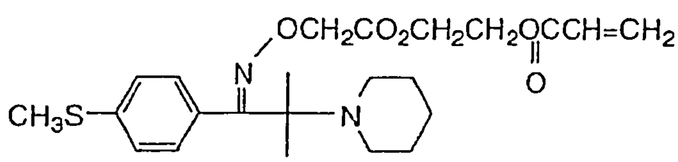

Further, N-phenylglycine and an N-phenylglycine sodium salt are enumerated.

The polymerization initiator can be used in an amount in the range of from 0.05 to 50 parts by weight, preferably from 0.1 to 40 parts by weight, and more preferably from 0.2 to 20 parts by weight based on 100 parts by weight of the ethylenically unsaturated bond-containing compound.

A compounding ratio of the titanocene compound to the triazine compound to be used in the invention is preferably from 1/19 to 19/1, and more preferably from 1/9 to 9/1 in terms of a weight ratio.

In the invention, it is preferable that the polymerization initiator is used in an amount in the range of from 0.01

% by weight to 50 % by weight based on the whole of components of the image recording layer. More preferably, the amount of the polymerization initiator is from 0.1 % by weight to 30 % by weight. In this range, good results are obtained. Further preferably, the amount of the polymerization initiator is in the range of from 0.5 % by weight to 20 % by weight.

Also, a compounding weight ratio of the titanocene compound to the trihalomethyl group-containing compound is preferably from 100/1 to 1/100, more preferably from 50/1 to 1/50, and further preferably from 10/1 to 1/10.

<Sensitizing dye>

It is preferable that the photoinitiation system of the invention contains a sensitizing dye in addition to the polymerization initiator.

The sensitizing dye is known in a lot of patents and documents and can be adequately chosen from dyes having sensitivity to light sources such as ultraviolet rays, visible light, Ar ion laser, FD-YAG laser, and short-wavelength semiconductor laser and used. Examples thereof include photo-reducing dyes described in U.S. Patent No. 2,850,445; dialkylaminobenzilidene ketone dyes described in JP-B-47-2528; merocyanine dyes described in JP-A-54-151024; 3-ketocoumarin dyes described in JP-A-58-15503; cyanine dyes and merocyanine dyes described in JP-A-59-140203, JP-A-62-174203, and JP-A-2-63054; dyes having a rhodanine skeleton described in JP-A-2-244050; xanthene based dyes described in JP-A-4-219756; merocyanine based dyes described in JP-A-6-295061; dyes having a benzopyran system described in JP-A-8-334897; and sensitizing dyes described in B.M. Monroe, *Chemical Review,* General Remarks, Vol. 93, pp.435-448 (1993) and D.F. Eaton, *Advance in Photochemistry,* Vol. 13, pp.427-480 (1986). In particular, dyes having high sensitivity at from 350 to 450 nm such as merocyanine dyes described in JP-A-2000-147763, carbazole type dyes described in JP-A-2001-42524, merocyanine dyes described in JP-A-2003-21895, and dyes having an oxazolidinone skeleton described in Japanese Patent Application Nos. 11-290204 and 2002-021723 are useful as the sensitizing dye.

Similar to the foregoing addition polymerizable compound, the use method of the sensitizing dye can be arbitrarily set up according to the performance design of the photosensitive material. For example, by using two or more kinds of the sensitizing dyes jointly, it is possible to enhance affinity with the image recording layer. In choosing the sensitizing dye, besides the photosensitivity, a molar extinction coefficient at the emitting wavelength of a light source to be used is an important factor. By using a dye having a large molar extinction coefficient, the amount of the dye to be added can be made relatively low. Therefore, such is economical and advantageous in view of film physical properties of the image recording layer. Since the photosensitivity of the image recording layer, the resolution, and the physical properties of the exposed film are largely influenced by an absorbance at the light source wavelength, the addition amount of the sensitizing dye is adequately chosen while taking into account these matters. For example, the sensitivity lowers in a low-absorbance region of not more than 0.1. Also, the resolution becomes low due to an influence of halation. However, for example, for the purpose of curing a thick film of 5 μm or more, there may be the case where such a low absorbance rather increases the degree of curing. Also, in a high-absorbance region of 3 or more, the major part of light is absorbed on the surface of the image recording layer so that curing of the inner portion is inhibited. Thus, for example, when applied as a printing plate, the film strength and the adhesion to a substrate become insufficient. In using as a lithographic printing plate to be used in the state that the film thickness is relatively thin, it is preferred to set up the addition amount of the sensitizing dye such that the absorbance of the image recording layer falls within the range of from 0.1 to 3.0, and preferably from 0.25 to 1.5. In the case of use as a lithographic printing plate, the addition amount of the sensitizing dye is in general in the range of from 0. 05 to 30 parts by weight, preferably from 0. 1 to 20 parts by weight, and more preferably from 0.2 to 10 parts by weight based on 100 parts by weight of the components of the image recording layer.

As the sensitizing dye which is used in the invention, laser light absorbing dyes (sensitizing dyes) having an absorption maximum wavelength at the range of from 330 to 430 nm are preferable.

For example, in the case where light in the vicinity of 400 nm is used as a light source, benzil, benzoin ether, Michler's ketone, anthraquinone, thioxanthone, acridine, phenazine, and benzophenone can be used.

Also, in the case where rays of 330 nm or longer, Ar laser, a second harmonic of semiconductor laser, or YAG laser is used as the light source, a variety of photoinitiation systems are proposed. Examples include systems composed of a combination of a certain kind of photo-reducing dye (for example, Rose Bengale, Eosine, and Erythrocin) or a dye and a photoinitiator as described in U.S. Patent No. 2,850,445; composite initiation systems composed of a dye and an amine (see JP-B-44-20189); combined systems composed of a hexaaryl biimidazole, a radical generator, and a dye (see JP-B-45-37377); systems composed of a hexaaryl biimidazole and a p-dialkylaminobenzilidene ketone (see JP-B-47-2528 and JP-A-54-155292); systems composed of a cyclic cis-α-dicarbonyl compound and a dye (see JP-A-48-84183), systems composed of a cyclic triazine and a merocyanine dye (see JP-A-54-151024); systems composed of 3-keto coumarin and an activator (see JP-A-52-112:681 and JP-A-58-15503); systems composed of biimidazole, a styrene derivative, and a thiol (JP-A-59-140203); systems composed of an organic peroxide and a dye (see JP-A-59-1504, JP-A-59-140203, JP-A-59-189340, JP-A-62-174203, JP-B-62-1641, and U.S. Patent No. 4,766,055); systems of a dye and an active halide (see JP-A-63-178105, JP-A-63-258903, and JP-A-2-63054); systems composed of a dye and a borate compound (see JP-A-62-143044, JP-A-62-150242, JP-A-64-13140, JP-A-64-13141, JP-A-64-13142, JP-A-64-13143, JP-A-64-13144, JP-A-64-17048, JP-A-1-229003, JP-A-1-298348, and JP-A-1-138204); systems composed of a rhodanine ring-containing dye and a radical initiator (see JP-A-2-179643 and JP-A-2-244050); systems composed of titanocene and a 3-keto coumarin dye (see JP-A-63-221110); systems composed of a combination of titanocene, a xathantene dye, and an amino group- or urethane group-containing addition polymerizable, ethylenically unsaturated compound (see JP-A-4-221958 and JP-A-4-219756); systems composed of titanocene and a specific merocyanine dye (see JP-A-6-295061); and systems composed of titanocene and a benzopyran ring-containing dye (see JP-A-8-334897).

As the laser light absorbing dyes (sensitizing dyes), dyes having an absorption wavelength at a short wavelength region of from 350 to 450 nm are preferably used.

As the laser light absorbing dyes to be used in the invention, ones which have hitherto been known as a sensitizing dye for laser exposure can be used. Examples thereof include triaryl based sensitizing dyes described in JP-A-2003-221517.

The sensitizing dye that is preferably used in the invention is a compound represented by the following genral formula (4).

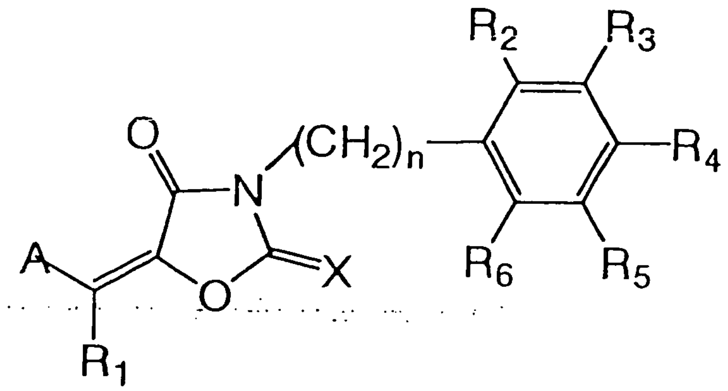

(4)

In the formula (4), A represents an optionally substituted aromatic ring or heterocyclic ring; X represents an oxygen atom, a sulfur atom, or $=NR_7$; and $R_1$, $R_2$, $R_3$, $R_4$, $R_5$, $R_6$, and $R_7$ each independently represents a hydrogen atom or a monovalent non-metallic atomic group, provided that at least one of $R_2$, $R_3$, $R_4$, $R_5$, and $R_6$ represents a substituent represented by $-OR_8$, wherein $R_8$s each independently represents a monovalent non-metallic atomic group; and n represents an integer of from 1 to 6.

The formula (4) will be described below in detail.

Preferred examples of the monovalent non-metallic atomic group represented by $R_1$, $R_2$, $R_3$, $R_4$, $R_5$, $R_6$, $R_7$, and $R_8$ (hereinafter sometimes abbreviated as "$R_1$ to $R_8$") include a substituted or unsubstituted alkyl group, a substituted or unsubstituted alkenyl group, a substituted or unsubstituted aryl group, a substituted or unsubstituted aromatic heterocyclic group, a substituted or unsubstituted alkynyl group, a substituted or unsubstituted alkoxy group, a substituted or unsubstituted alkylthio group, a hydroxyl group, an acyl group, and a halogen atom.

Preferred examples of $R_1$ to $R_8$ will be specifically described below.

Preferred examples of the alkyl group include linear, branched or cyclic alkyl groups having from 1 to 20 carbon atoms. Specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an isopropyl group, an isobutyl group, a s-butyl group, a t-butyl group, an isopentyl group, a neopentyl group, a 1-methylbutyl group, an isohexyl group, a 2-ethylhexyl group, a 2-methylhexyl group, a cyclohexyl group, a cyclopentyl group, and a 2-norbornyl group. Of these, linear alkyl groups having from 1 to 12 carbon atoms, branched alkyl groups having from 3 to 12 carbon atoms, and cyclic alkyl groups having from 5 to 10 carbon atoms are more preferable.

As the substituent of the substituted alkyl group, a monovalent non-metallic atomic group exclusive of hydrogen is used. Preferred examples thereof include a halogen atom (for example, -F, -Br, -Cl, and -I), a hydroxyl group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group,
an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group ($-SO_3H$) and its conjugated base group (hereinafter referred to as "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group ($-PO_3H_2$) and its conjugated base group (hereinafter referred to as "phosphonato group"), a dialkylphosphono group ($-PO_3(alkyl)_2$), a diarylphosphono group ($-PO_3(aryl)_2$), an alkylarylphosphono group ($-PO_3(alkyl)(aryl)$), a monoalkylphosphono group ($-PO_3H(alkyl)$) and its conjugated base group (hereinafter referred to as "alkylphosphonato group"), a monoarylphosphono group ($-PO_3H(aryl)$) and its conjugated base group (hereinafter referred to as "arylphosphonato group"), a phosphonooxy group ($-OPO_3H_2$) and its conjugated base group (hereinafter referred to as "phosphonatooxy group"), a dialkylphosphonooxy group ($-OPO_3(alkyl)_2$), a diarylphosphonooxy group ($-OPO_3(aryl)_2$), an alkylarylphosphonooxy group ($-OPO_3(alkyl)(aryl)$), a mono-alkylphosphonooxy group ($-OPO_3H(alkyl)$) and its conjugated base group (hereinafter referred to as "alkylphosphonatooxy group"), a monoarylphosphonooxy group ($-OPO_3H(aryl)$) and its conjugated base group (hereinafter referred to as "arylphosphonatooxy group"), a cyano group, a nitro group, an aryl group, a heteroaryl group, an alkenyl group, and an alkynyl group.

In these substituents, as specific examples of the alkyl group, the foregoing alkyl groups are enumerated. Specific examples of the aryl group include a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxyphenylcarbonyl group, a phenoxycarbonylphenyl group, an N-phenylcarbamoylphenyl group, a phenyl group, a cyanophenyl group, a sulfophenyl group, a sulfonatophenyl group, a phosphonophenyl group, and a phosphonatophenyl group.

As the preferred aromatic heterocyclic group represented by $R_1$ to $R_8$, monocyclic or polycyclic aromatic rings containing at least one of a nitrogen atom, an oxygen atom, and a sulfur atom are used. Examples of especially preferred aromatic heterocyclic groups include thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indoyl, indazole, purine, quinolizine, isoquinoline, phthalazine, naphthylidine, quinazoline, cinnoline, pteridine, carbazole, carboline, phenanthrene, acridine, perimidine, phenanthroline, phthalazine, phenarsazine, phenoxazine, furazane, and phenoxazine. These groups may be benzo-fused or may have a substituent.

Also, preferred examples of the alkenyl group represented by $R_1$ to $R_8$ include a vinyl group, a 1-propenyl group, a 1-butenyl group, a cinnamyl group, and a 2-chloro-1-ethenyl group; and examples of the alkynyl group include an ethynyl group, a 1-propynyl group, a 1-butynyl group, and a trimethylsilylethynyl group. As G1 in the acyl group (G1CO-), hydrogen and the foregoing alkyl groups and aryl groups can be enumerated.

Of these substituents, a halogen atom (for example, -F, - Br, -Cl, and -I), an alkoxy group, an aryloxy group, an alkylthio group, an arylthio group, an N-alkylamino group, an N,N-dialkylamino group, an acyloxy group, an N-alkylcarbamoyloxy group, an N-arylcarbamoyloxy group, an acylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N-alkyl-N-arylcarbamoyl group, a sulfo group, a sulfonato group, a sulfamoyl group, an N-alkylsulfamoyl group, an N,N-dialkylsulfamoyl group, an N-arylsulfamoyl group, an N-alkyl-N-arylsulfamoyl group, a phosphono group, a phosphonato group, a dialkylphosphonato group, a diarylphosphono group, a monoalkylphosphono group, an alkylphosphonato group, a monoarylphosphono group, an arylphosphonato group, a phosphonooxy group, a phosphonatooxy group, an aryl group, and an alkenyl group are more preferable.

On the other hand, as the alkylene group in the substituted alkyl group, divalent organic residual groups resulting from elimination of any one of hydrogen atoms on the foregoing alkyl group having from 1 to 20 carbon atoms

can be enumerated. Linear alkylene groups having from 1 to 12 carbon atoms, branched alkylene groups having from 3 to 12 carbon atoms, and cyclic alkylene groups having from 5 to 10 carbon atoms can be enumerated.

Specific examples of the preferred substituted alkyl group represented by $R_1$ to $R_8$, which is obtained by combining the foregoing substituent with an alkylene group, include a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an $\alpha$-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group, and a 3-butynyl group.

Further, specific examples of the preferred aryl group represented by $R_1$ to $R_8$ include a fused ring formed from one to three benzene rings and a fused ring formed from a benzene ring and a 5-membered unsaturated ring. Specific examples thereof include a phenyl group, a naphthyl group, an anthryl group, a phenanthryl group, an indenyl group, an acenaphthenyl group, and a fluorenyl group. Of these, a phenyl group and a naphthyl group are more preferable.

As specific examples of the preferred substituted aryl group represented by $R_1$ to $R_8$, ones having a monovalent non-metallic atomic group exclusive of hydrogen as a substituent on the carbon atoms forming a ring of the foregoing aryl group are used. Preferred examples of the substituent include the foregoing alkyl groups and substituted alkyl groups, and those enumerated as a substituent in the foregoing substituted alkyl group. Specific examples of the substituted aryl group include a biphenyl group, a tolyl group, a xylyl group, a mesityl group, a cumenyl group, a chlorophenyl group, a bromophenyl group, a fluorophenyl group, a chloromethylphenyl group, a trifluoromethylphenyl group, a hydroxyphenyl group, a methoxyphenyl group, a methoxyethoxyphenyl group, an allyloxyphenyl group, a phenoxyphenyl group, a methylthiophenyl group, a tolylthiophenyl group, an ethylaminophenyl group, a diethylaminophenyl group, a morpholinophenyl group, an acetyloxyphenyl group, a benzoyloxyphenyl group, an N-cyclohexylcarbamoyloxyphenyl group, an N-phenylcarbamoyloxyphenyl group, an acetylaminophenyl group, an N-methylbenzoylaminophenyl group, a carboxyphenyl group, a methoxycarbonylphenyl group, an allyloxycarbonylphenyl group, a chlorophenoxycarbonylphenyl group, a carbamoylphenyl group, an N-methylcarbamoylphenyl group, an N,N-dipropylcarbamoylphenyl group, an N-(methoxyphenyl)carbamoylphenyl group, an N-methyl-N-(sulfophenyl)carbamoylphenyl group, a sulfophenyl group, a sulfonatophenyl group, a sulfamoylphenyl group, an N-ethylsulfamoylphenyl group, an N,N-dipropylsulfamoylphenyl group, an N-tolylsulfamoylphenyl group, an N-methyl-N-(phosphonophenyl)sulfamoylphenyl group, a phosphonophenyl group, a phosphonatophenyl group, a diethylphosphonophenyl group, a diphenylphosphonophenyl group, a methylphosphonophenyl group, a methylphosphonatophenyl group, a tolylphosphonophenyl group, a tolylphosphonatophenyl group, an allyl group, a 1-propenylmethyl group, a 2-butenyl group, a 2-methylallylphenyl group, a 2-methylpropenylphenyl group, a 2-propenylphenyl group, a 2-butynylphenyl group, and a 3-butynylphenyl group.

As $R_2$, $R_3$, $R_4$, $R_5$, and $R_6$, a hydrogen atom or a substituted or unsubstituted alkyl group is especially preferable. Also, as $R_8$, a substituted or unsubstituted alkyl group is more preferable, and an ethyl group or a methyl group is further preferable.

n is preferably from 2 to 5, and more preferably 2 or 3.

Next, A in the formula (4) will be described below. A represents an optionally substituted aromatic ring or hetero ring. As specific examples of the optionally substituted aromatic ring or hetero ring, those described for $R_1$ to $R_8$ in the fomula (4) are enumerated.

Among the foregoing sensitizing dyes represented by the fomula (4), a sensitizing dye having a structure represented by the following fomula (5) is especially preferable because it gives a photosensitive composition having a high sensitizing ability and excellent storage stability.

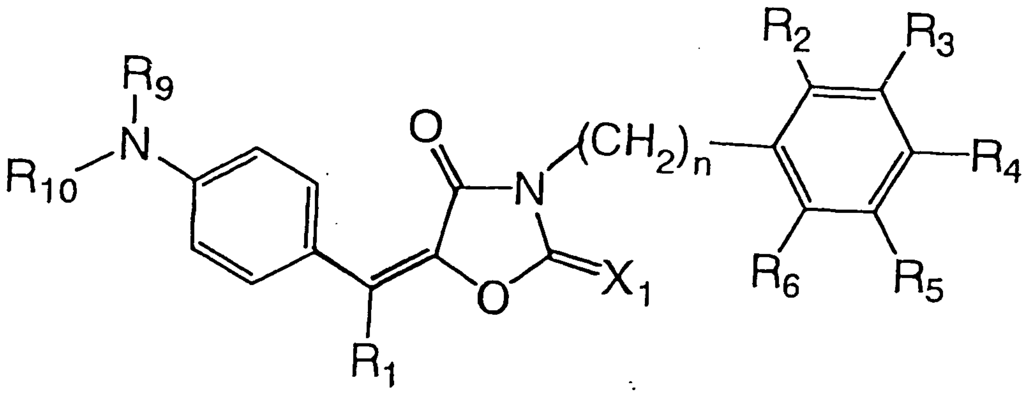

(5)

In the formula (5), $X_1$ represents an oxygen atom or a sulfur atom; $R_1$, $R_2$, $R_3$, $R_4$, $R_5$, and $R_6$ each independently represents a hydrogen atom or a monovalent non-metallic atomic group; $R_9$ and $R_{10}$ each independently represents a monovalent non-metallic atomic group, provided that at least one of $R_2$, $R_3$, $R_4$, $R_5$, and $R_6$ represents a substituent represented by $-OR_8$, wherein $R_8$s each independently represents a monovalent non-metallic atomic group; and n represents an integer of from 1 to 6.

In the formula (5), $R_1$, $R_2$, $R_3$, $R_4$, $R_5$, $R_6$, and $R_8$ are synonymous with those in the formula (4); and $R_9$ and $R_{10}$ each independently represents a monovalent non-metallic atomic group, and as specific examples thereof, the foregoing groups described in $R_2$, $R_3$, $R_4$, $R_5$, and $R_6$ are enumerated. As more preferred examples of $R_9$ and $R_{10}$, an optionally substituted aryl group or heterocyclic group is enumerated.

The sensitizing dyes of the invention represented by the formulae (4) and (5) are obtained by condensation reaction of the foregoing acidic nucleus or an active methyl group-containing acidic nucleus with a substituted or unsubstituted aromatic ring or hetero ring and can be synthesized by referring to JP-B-59-28329.

Preferred specific examples (D1) to (D32) of the compound represented by the fomula (4) will be given below, but it should not be construed that the invention is limited thereto. Also, isomers by a double bond connecting an acidic nucleus and a basic nucleus are not clarified, and the invention is never limited to any isomer.

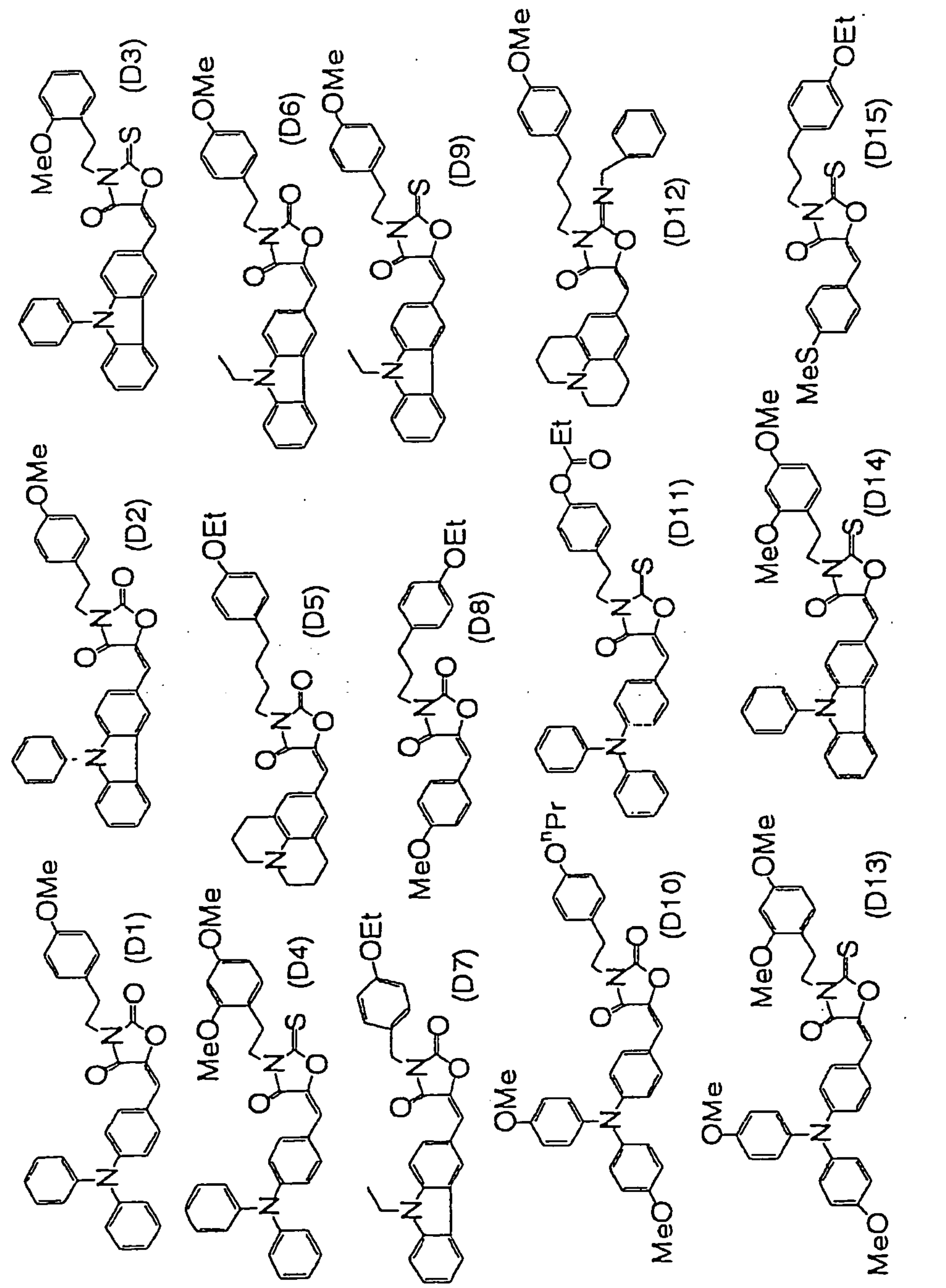

(D1) (D2) (D3) (D4) (D5) (D6) (D7) (D8) (D9) (D10) (D11) (D12) (D13) (D14) (D15)

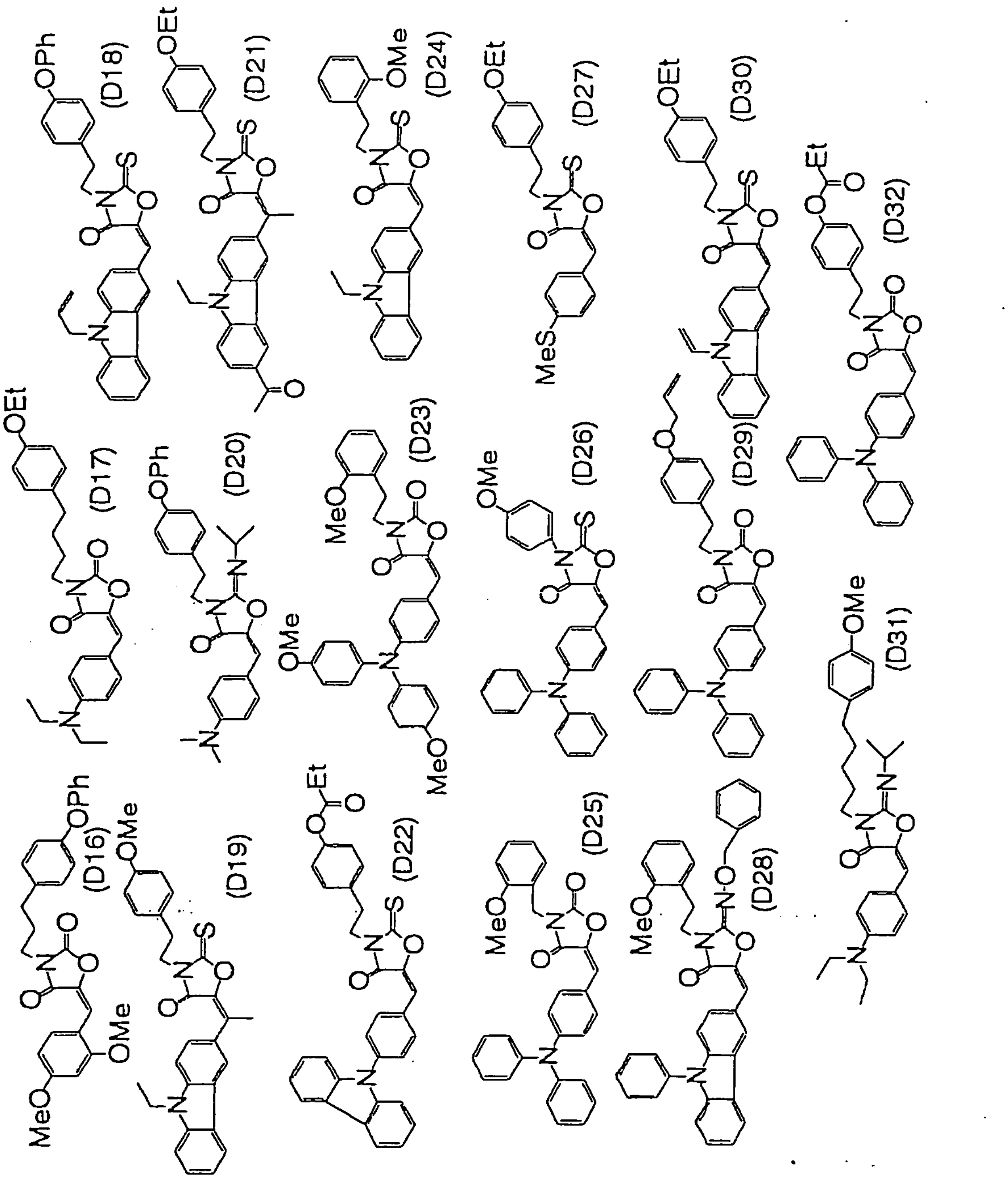

(D16) (D17) (D18) (D19) (D20) (D21) (D22) (D23) (D24) (D25) (D26) (D27) (D28) (D29) (D30) (D31) (D32)

For the purpose of further improving the characteristics of the image recording layer, the sensitizing dye of the invention can be subjected to a variety of chemical modifications. For example, by binding the sensitizing dye with an addition polymerizable chemical structure (for example, an acryloyl group and a methacryloyl group) by covalent bond, ionic bond, hydrogen bond, and other methods, it is possible to increase the strength of the exposed film and to suppress unnecessary deposition of the dye from the film after exposure. Also, by binding the sensitizing dye with a radical, acid or base generating part of an activator compound as described later, it is possible to remarkably enhance the sensitivity especially in the low concentration state of the initiation system. Further, for the purpose of enhancing the treatment adaptability to an (alkaline) aqueous developing solution as a preferred use embodiment of the image recording layer of the invention, it is effective to introduce a hydrophilic site (for example, acid groups or polar groups such as a carboxyl group and its esters, a sulfonic group and its esters, and an ethylene oxide group). Especially, ester type hydrophilic groups have such characteristic features that since they have a relatively hydrophobic structure in the image recording layer, they are excellent in the affinity and that they generate an acid group upon hydrolysis in the

developing solution, whereby the hydrophilicity increases. Besides, for example, it is possible to adequately introduce a substituent for the purposes of enhancing the affinity in the image recording layer and suppressing the crystal deposition. For example, in certain photosensitive systems, there may be the case where an aryl group or an unsaturated bond such as an allyl group is very effective in an enhancement of the affinity. Also, by a method of introducing a branched alkyl structure or other methods, when a steric hindrance is introduced between dye $\pi$ planes, the crystal deposition can be remarkably suppressed. Also, by introducing a phosphonic group, an epoxy group, a trialkoxysilyl group, etc., it is possible to enhance the adhesion to inorganic materials such as metals and metal oxides. Besides, it is possible to utilize polymerization of the sensitizing dye or other methods depending upon the purpose.

Details in the use method, such as what structure of the sensitizing dye be used, whether the sensitizing dye be used singly or in combinations of two or more thereof, and what addition amount be employed, can be adequately set up depending upon the performance design of the final photosensitive material. For example, by using two or more sensitizing dyes jointly, it is possible to enhance the affinity with the image recording layer. In choosing the sensitizing dye, in addition to the photosensitivity, a molar extinction coefficient at the emitting wavelength of a light source to be used is an important factor. By using a dye having a large molar extinction coefficient, the amount of the dye to be added can be made relatively low. Therefore, such is economical and advantageous in view of film physical properties of the image recording layer. Since the photosensitivity of the image recording layer, the resolution, and the physical properties of the exposed film are largely influenced by an absorbance at the light source wavelength, the addition amount of the sensitizing dye is adequately chosen while taking into account these matters. In using as a lithographic printing plate in which the film thickness is relatively thin, it is preferred to set up the addition amount of the sensitizing dye such that the absorbance of the image recording layer falls within the range of from 0.1 to 1.5, and preferably from 0.25 to 1.

In the invention, the addition amount of the sensitizing dye is preferably from 0.1 to 30 % by weight, more preferably from 0.3 to 15 % by weight, and further preferably from 0.5 to 10 % by weight based on the whole of components of the image recording layer. Also, in the case of utilization as a lithographic printing plate, the addition amount of the sensitizing dye is usually in the range of from 0. 05 to 30 parts by weight, preferably from 0.1 to 20 parts by weight, and further preferably from 0.2 to 10 parts by weight based on 100 parts by weight of the components of the image recording layer. <Other components>

In addition to the foregoing components, the photopolymerizable composition of the invention can contain a variety of compounds such as heat polymerization inhibitors, coloring agents, and plasticizers as the need arises.

Examples of heat polymerization inhibitors include hydroquinone, p-methoxyphenol, di-t-butyl-p-cresol, pyrogallol, t-butylcatechol, benzoquinone, 4,4-thiobis(3-methyl-6-t-butylphenol), 2,2'-methylenebis(4-methyl-6-t-butylphenol), an N-nitrosophenylhydroxylamine cerium(III) salt, and an N-nitrosophenylhydroxylamine ammonium salt. The addition amount of the heat polymerization inhibitor is preferably from about 0.01 % to about 5 % based on the weight of the whole composition. Also, if desired, for the sake of preventing polymerization hindrance by oxygen, a higher fatty acid derivative such as behenic acid and behenic amide or the like may be added and unevenly distributed on the surface of the image recording layer in the drying step after coating. The addition amount of the higher fatty acid derivative or the like is preferably from about 0.5 % by weight to about 10 % by weight of the whole composition.

Further, for the purpose of coloring the image recording layer, a coloring agent may be added. Examples of the coloring agent include phthalocyanine based pigments (for example, C. I. Pigment Blue 15:3, C.I. Pigment Blue 15:4, and C.I. Pigment Blue 15: 6), azo based pigments, pigments such as carbon black and titanium oxide, Ethyl Violet, Crystal Violet, azo dyes, anthraquinone based dyes, and cyanine based dyes. The addition amount of the dye or pigment is preferably from about 0.5 % by weight to about 20 % by weight of the whole composition. In addition, for the sake of improving physical properties of the cured film, additives such as inorganic fillers and plasticizers (for example, dioctyl phthalate, dimethyl phthalate, and tricresyl phosphate) may be added. The addition amount of the additive is preferably not more than 10 % by weight of the whole composition.

For the sake of enhancing the coating surface quality, a surfactant can be added to the photopolymerizable composition of the invention. The coating amount is properly in the range of from about 0.1 g/m$^2$ to about 10 g/m$^2$, more preferably from 0.3 to 5 g/m$^2$, and further preferably from 0.5 to 3 g/m$^2$ in terms of a weight after drying.

<Description of use embodiment in lithographic printing plate>

Next, the case where an image recording material provided with an image recording layer containing the photopolymerizable composition of the invention is applied to a lithographic printing plate will be described below. In general, in a lithographic printing plate, there is employed an embodiment in which a photosensitive layer (image recording layer) containing the foregoing photopolymerizable composition and optionally, an interlayer and a protective layer are provided on a support such as an aluminum plate.

In order to provide the foregoing photopolymerizable composition on a support, prescribed amounts of the foregoing ethylenically unsaturated bond-containing compound, binder and photopolymerization initiation system, and

optionally, various additives are dissolved in an adequate organic solvent to prepare a coating solution for image recording layer, which may be then coated on the support and dried. Examples of the solvent to be used herein include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl acetate-3-methoxypropyl acetate, N,N-dimethylformamide, dimethyl sulfoxide, γ-butyrolactone, methyl lactate, and ethyl lactate. These solvents can be used singly or in admixture. Incidentally, the concentration of the solids in the coating solution is properly from 1 to 50 % by weight.

(Support)

For the sake of obtaining a lithographic printing plate, an aspect of which is one of the major objects of the invention, it is desired that the foregoing image recording layer is provided on a support, the surface of which is hydrophilic. As the hydrophilic support, hydrophilic supports which have hitherto been known and employed in lithographic printing plates can be used without limitations. As the support to be used, a plate-like material that is dimensionally stable is preferable. Examples thereof include papers, papers laminated with a plastic (for example, polyethylene, polypropylene, and polystyrene), metal plates (for example, aluminum, zinc, and copper), plastic films (for example, cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, and polyvinyl acetal), and papers or plastic films laminated or vapor deposited with the foregoing metal. If desired, the surface of the support may be subjected to a proper known physical or chemical treatment for the purpose of imparting hydrophilicity, enhancing the strength, or the like.

Papers, polyester films, and aluminum plates are especially preferable as the support. Above all, aluminum plates that are dimensionally stable and relatively cheap and can provide a surface excellent in the hydrophilicity or strength by the surface treatment as the need arises are especially preferable. Also, composite sheets having an aluminum sheet bound on a polyethylene terephthalate film, as described in JP-B-48-18327, are preferable.

An aluminum substrate is a metal plate containing dimensionally stable aluminum as the major component and is selected from not only a pure aluminum plate but also alloy plates containing aluminum as the major component and a trace amount of foreign elements and plastic films or papers laminated or vapor deposited with aluminum (or an alloy thereof).

In the following description, the foregoing substrate made of aluminum or an aluminum alloy will be generically named "aluminum substrate". Examples of foreign elements to be contained in the foregoing aluminum alloy include silicon, iron, manganese, copper, magnesium, chromium, zinc, bismuth, nickel, and titanium, and the content of such foreign elements in the alloy is not more than 10 % by weight. In the invention, though a pure aluminum plate is suitable, since it is difficult to produce completely pure aluminum in the smelting technologies, a trace amount of foreign elements may be contained.

The aluminum plate which is applied in the invention is not specified with respect to its formulation, and materials which have hitherto been publicly known and used, such as JIS A1050, JIS A1100, JIS A3103, and JIS A3005, can be adequately utilized. Also, the aluminum substrate which is used in the invention has a thickness of from about 0.1 mm to 0.6 mm, preferably 0.15 mm to 0.4 mm, and especially preferably from 0.2 mm to 0.3 mm. This thickness can be adequately changed depending upon the size of a printing machine, the size of a printing plate, and the desire of users. The aluminum substrate may be subjected to a substrate surface treatment as described later as the need arises. As a matter of course, the aluminum substrate may not be subjected to a substrate surface treatment.

[Roughing treatment]

The aluminum substrate is usually subjected to a roughing treatment. Examples of the roughing treatment include mechanical roughing, chemical etching, and electrolytic graining as disclosed in JP-A-56-28893. Further, an electrochemical roughing method of performing electrochemical roughing in a hydrochloric acid or nitric acid electrolytic liquid and mechanical roughing treatments such as a wire brush graining method of scratching the aluminum surface using a metallic wire, a ball graining method of sand blasting the aluminum surface using polishing spheres and a polishing agent, and a brush graining method of roughing the surface using a nylon brush and a polishing agent can be employed. The foregoing roughing methods can be employed singly or in combinations. Of these methods, an electrochemical method of performing electrochemical roughing in a hydrochloric acid or nitric acid electrolytic liquid is useful as the roughing. The quantity of electricity at the time of anodization is in the range of from 50 $C/dm^2$ to 400

C/dm$^2$. More specifically, it is preferable that alternating current and/or direct current electrolysis is carried out in an electrolytic liquid containing from 0. 1 to 50 % of hydrochloric acid or nitric acid under conditions at a temperature of from 20 to 80 °C, for a time of from one second to 30 minutes, and at a current density of from 100 C/dm$^2$ to 400 C/dm$^2$.

The roughed aluminum substrate may be chemically etched with an acid or an alkali. Examples of etching agents which are suitably used include sodium hydroxide, sodium carbonate, sodium aluminate, sodium metasilicate, sodium phosphate, potassium hydroxide, and lithium hydroxide. The concentration and the temperature are preferably from 1 to 50 % and from 20 to 100 °C, respectively. For the sake of removing stains (smuts) remaining on the surface after etching, acid washing is carried out. Examples of acids to be used include nitric acid, sulfuric acid, phosphoric acid, chromic acid, hydrofluoric acid, and borofluoric acid. In particular, as the method of removing smuts after the electrochemical roughing treatment, a method of bringing into contact with sulfuric acid of from 15 to 65 % by weight at a temperature of from 50 to 90 °C as described in JP-A-53-12739 and a method of performing alkali etching as described in JP-B-48-28123 are preferable. So far as the thus treated surface has a center line average height (Ra) of from 0.2 to 0.5 μm, there are no particular limitations with respect to the method and conditions.

[Anodic oxidation treatment]

The thus roughed aluminum substrate is then subjected to an anodic oxidation treatment to form an oxidized film. In the anodic oxidation treatment, an aqueous solution of sulfuric acid, phosphoric acid, oxalic acid, or boric acid/ sodium borate is used singly or in combinations as the major component of an electrolytic bath. In this case, as a matter of course, the electrolytic liquid may contain components that are at least usually contained in an Al alloy plate, electrodes, city water, ground water, etc. Further, second or third components may be added to the electrolytic liquid. Examples of the second or third components as referred to herein include cations such as metal ions of Na, K, Mg, Li, Ca, Ti, Al, V, Cr, Mn, Fe, Co, Ni, Cu, Zn, etc. and an ammonium ion; and anions such as a nitric acid ion, a carbonic acid ion, a chlorine ion, a phosphoric acid ion, a fluorine ion, a sulfurous acid ion, a titanic acid ion, a silicic acid ion, and a boric acid ion. These second or third components may be contained in a concentration of from about 0 to 10, 000 ppm. Though the conditions of the anodic oxidation treatment are not particularly limited, the anodic oxidation treatment is preferably carried out by direct current or alternating current electrolysis in an amount of from 30 to 500 g/L, at a treatment liquid temperature of from 10 to 70 °C at a current density in the range of from 0.1 to 40 A/m$^2$. The formed anodically oxidized film has a thickness in the range of from 0.5 to 1.5 μm, and preferably from 0.5 to 1.0 μm.

Further, ones which after these treatments, are undercoated with a water-soluble resin (for example, polyvinylphosphonic acid and polymers or copolymers having a sulfonic group in the side chain), polyacrylic acid, a water-soluble metal salt (for example, zinc borate), a yellow dye, an amine salt, etc. are also suitable. Moreover, sol-gel treated substrates resulting from covalent bonding with a functional group capable of causing addition reaction by a radical, as disclosed in JP-A-7-159983, are also suitable.

Besides, ones provided with a waterproof hydrophilic layer as a surface layer on an arbitrary support can be enumerated as a preferred example. Examples of such a surface layer include layers made of an inorganic pigment and a binder as described in U.S. Patent No. 3,055,295 and JP-A-56-13168; hydrophilic swelling layers described in JP-A-9-80744; and sol-gel films made of titanium oxide, polyvinyl alcohol, and a silicate as described in JP-T-8-507727. These hydrophilic treatments are applied for the purposes of not only making the surface of the support hydrophilic but also preventing noxious reaction of the photopolymerizable composition to be provided thereon from occurrence and enhancing the adhesion of the image recording layer.

[Interlayer]

For the purpose of improving the adhesion between the photosensitive layer and the substrate and staining resistance, an interlayer may be provided in a lithographic printing plate precursor in the invention. Specific examples of such an interlayer include ones described in JP-B-50-7481, JP-A-54-72104, JP-A-59-101651, JP-A-60-149491, JP-A-60-232998, JP-A-3-56177, JP-A-4-282637, JP-A-5-16558, JP-A-5-246171, JP-A-7-159983, JP-A-7-314937, JP-A-8-202025, JP-A-8-320551, JP-A-9-34104, JP-A-9-236911, JP-A-9-269593, JP-A-10-69092, JP-A-10-115931, JP-A-10-161317, JP-A-10-260536, JP-A-10-282682, JP-A-11-84674, JP-A-11-38635, JP-A-11-38629, JP-A-10-282645, JP-A-10-301262, JP-A-11-24277, JP-A-11-109641, JP-A-10-319600, JP-A-11-327152, JP-A-2000-10292, JP-A-2000-235254, JP-A-2000-352824, and JP-A-2001-209170.

[Protective layer]

In the case where the photopolymerizable composition of the invention is applied to a lithographic printing plate for scanning exposure, since exposure is usually carried out in the air, it is preferred to further provide a protective layer on the image recording layer containing the photopolymerizable composition. The protective layer prevents incorporation of low-molecular compounds (for example, oxygen and basic substances) present in the air, which likely inhibit image formation reaction caused by the exposure in the image recording layer, thereby making it possible to achieve exposure in the air. Accordingly, a characteristic that such a protective layer is desired to have is that permeability against low-molecular compounds such as oxygen is low. Further, it is desired that the protective layer does not substantially inhibit transmission of light to be used for the exposure, has excellent adhesion to the image recording layer, and can be easily removed in a development step after the exposure. With respect to such a protective layer, devices have hitherto been made, and details are described in U.S. Patent No. 3,458,311 and JP-A-55-49729.

Examples of materials that can be used in the protective layer include water-soluble high-molecular compounds having relatively excellent crystallinity. Specific examples include water-soluble polymers such as polyvinyl alcohol, polyvinylpyrrolidone, acidic celluloses, gelatin, gum arabic, and polyacrylic acid. Especially, the case where polyvinyl alcohol is used as the major component gives the best results in view of basic characteristics such as oxygen shielding property and development eliminating property. Since the polyvinyl alcohol to be used in the protective layer possesses necessary oxygen shielding and water solubility, it may be partially substituted with an ester, an ether, or an acetal so far as it contains a unsubstituted vinyl alcohol unit. Also, a part of the polyvinyl alcohol similarly has other copolymerization component. Specific examples of the polyvinyl alcohol include ones which are hydrolyzed to an extent of from 71 to 100 % and which have a molecular weight in the range of from 300 to 2,400.

Specifically, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, and L-8, all of which are manufactured by Kuraray Co., Ltd., are enumerated.

Components of the protective layer (for example, selection of PVA and use of additives) , coating amount and the like are chosen while taking into account not only oxygen shielding property and development eliminating property but also fogging property, adhesion, and scratch resistance. In general, as the degree of hydrolysis of PVA to be used is high (the content of the unsubstituted vinyl alcohol in the protective layer is high), and the film thickness is thick, the oxygen shielding property is high, and such is advantageous in view of sensitivity. However, when the oxygen shielding property is made extremely high, there are caused such problems that unnecessary polymerization reaction occurs at the time of production or unprocessed stock and that unnecessary fogging or thickening of image lines is caused at the time of image exposure. Also, adhesion to an image portion and scratch resistance are extremely important in view of handling of a plate.

As countermeasures against these problems, it is known that a hydrophilic polymer composed mainly of polyvinyl alcohol is mixed with from 5 to 80 % by weight of an additive such as an acrylic emulsion and a water-insoluble vinyl-pyrrolidone-vinyl acetate copolymer, which is then laminated on the polymerization layer. All of these known technologies can be applied to the protective layer in the invention. The coating method of the protective layer is described in, for example, U.S. Patent No. 3,458,311 and JP-A-55-49729.

Further, it is possible to impart other function to the protective layer. For example, by adding a coloring agent (for example, water-soluble dyes) to be used for exposure, which is excellent in the transission to light of from 350 nm to 450 nm and can efficiently absorb light of 500 nm or longer, safelight adaptability can be enhanced without causing a lowering of the sensitivity.

In using the photosensitive material using the photopolymerizable composition of the invention as an image forming material, in general, after image exposure, an unexposed portion of the image recording layer is removed using a developing solution, to obtain an image.

Besides, as a plate-making process of the lithographic printing plate precursor of the invention, the entire surface may be heated before or during the exposure, or during the time of from exposure to development. By heating, the image forming reaction in the image recording layer is accelerated, resulting in advantages such as an enhancement of the sensitivity or printing resistance and stabilization of the sensitivity. Further, for the purpose of enhancing the image strength and printing resistance, it is also effective to subject an image after the development to entire post heating or entire exposure. In general, it is preferable that heating before the development is carried out under mild conditions at not higher than 150 °C. When the temperature is too high, there is encountered such a problem that even a non-image portion is fogged. For heating after the development, very server conditions are utilized. In general, the heating after the development is carried out at a temperature in the range of from 200 to 500 °C. When the temperature is too low, a satisfactory image reinforcing action is not obtained. On the other hand, in the case where the temperature is too high, there is encountered such a problem that deterioration of the support or heat decomposition of the image portion occurs.

As the exposure method of a lithographic printing plate for scanning exposure to which the composition of the invention can be applied, known methods can be employed without limitations. A desired wavelength of the light source is from 350 nm to 450 nm, and specifically, an InGaN based semiconductor laser is suitable. As the exposure mechanism, any of an internal drum system, an external drum system, and a flat bed system may be employed. Also, by using a material having high water solubility as the component of the image recording layer of the invention, it is possible to make it soluble in neutral water or weakly alkaline water. However, a system in which after installing the

lithographic printing plate having such a construction, it is subjected to exposure and development on the machine can be employed.

Also, examples of other exposure rays against the photopolymerizable composition according to the invention include ultra-high pressure, high pressure, medium pressure and low pressure mercury vapor lamps, chemical lamps, carbon arc lamps, xenon lamps, metal halide lamps, a variety of visible and ultraviolet laser lamps, fluorescent lamps, tungsten lamps, and sunlight. Available laser sources of from 350 nm to 450 nm are as follows. Examples of gas lasers include Ar ion lasers (364 nm, 351 nm, 10 mW to 1 W), Kr ion lasers (356 nm, 351 nm, 10 mW to 1 W), and He-Cd lasers (441 nm, 325 nm, 1 mW to 100 mW); examples of solid lasers include a combination of Nd:YAG ($YVO_4$) and SHG crystal × 2 times (355 nm, 5 mW to 1 W) and a combination of Cr:LiSAF and SHG crystal (430 nm, 10 mW); examples of semiconductor laser systems include $KNbO_3$ ring resonators (430 nm, 30 mW), a combination of waveguide type wavelength converter and AlGaAs and InGaAs semiconductor (380 nm to 450 nm, 5 mW to 100 mW), a combination of waveguide type wavelength converter and AlGaInP and AlGaAs semiconductor (300 nm to 350 nm, 5 mW to 100 mW), AlGaInN (350 nm to 450 nm, 5 mW to 30 mW) , and others; and examples of pulse lasers include $N_2$ lasers (337 nm, pulse: 0.1 to 10 mJ) and XeF (351 nm, pulse: 10 to 250 mJ) . Of these, AlGaInN semiconductor lasers (commercially available InGaN based semiconductor lasers: 400 to 410 nm, 5 to 30 mW) are especially suitable in view of wavelength characteristics and costs.

Also, with respect to the lithographic printing plate exposure device of a scanning exposure system, examples of the exposure mechanism include an internal drum system, an external drum system, and a flat bed system. As the light source, among the foregoing light sources, those capable of undergoing continuous oscillation can be preferably utilized. Actually, the following exposure devices are especially preferable in view of the relationship between the sensitivity of photosensitive material and the time of plate making.

Examples include internal drum system exposure devices of from single beam to triple beams using at least one gas laser or solid laser source such that the laser becomes a semiconductor laser of a total output of 20 mW or more; flat bed system exposure devices of multi-beams (from one to ten beams) using at least one semiconductor laser, gas laser or solid laser such that the total outlet becomes 20 mW or more; external drum system exposure devices of multi-beams (from one to nine beams) using at least one semiconductor laser, gas laser or solid laser such that the total outlet becomes 20 mW or more; and external drum system exposure devices of multi-beams (ten or more beams) using at least one semiconductor laser or solid conductor such that the total output becomes 20 mW or more. In the foregoing laser direct imaging type lithographic printing plate, in general, the following equation (eq1) is materialized among the sensitivity of photosensitive material: X ($J/cm^2$), the exposure area of photosensitive material: S ($cm^2$) , the powder of one laser source: q (W), the number of lasers: n, and the entire exposure time: t (s).

$$X \cdot S = n \cdot q \cdot t \qquad \text{(eq1)}$$

i) In the case of the internal drum (single beam) system, in general, the following equation (eq2) is materialized among the rotation number of laser: f (radian/s), the sub-scanning length of photosensitive material: Lx (cm), the resolution: Z (dot/cm), and the entire exposure time: t (s).

$$f \cdot Z \cdot t = Lx \qquad \text{(eq2)}$$

ii) In the case of the external drum (multi-beams) system, in general, the following equation (eq3) is materialized among the number of rotation of drum (radian/s), the sub-scanning length of photosensitive material: Lx (cm), the resolution: Z (dot/cm), the entire exposure time: t (s), and the number of beams (n).

$$F \cdot Z \cdot n \cdot t = Lx \qquad \text{(eq3)}$$

iii) In the case of the flat bed head (multi-beams) system, in general, the following equation (eq4) is materialized among the number of rotation of polygon mirror: H (radian/s), the sub-scanning length of photosensitive material: Lx (cm), the resolution: Z (dot/cm), the entire exposure time: t (s), and the number of beams (n).

$$H \cdot Z \cdot n \cdot t = Lx \qquad \text{(eq4)}$$

By substituting the exposure conditions required for actual printing plates of resolution (2,560 dpi), plate size (A1/B1, sub-scanning length: 42 inches), and about 20 sheets per hour and the photosensitive characteristics of the

photosensitive composition of the invention (photosensitive wavelength, sensitivity: about 0.1 mJ/$cm^2$) into the foregoing equations, it can be understood that in the photosensitive material of the invention, a combination with the multibeam exposure system using a laser having a total output of 20 mW or more is preferable. However, in the case of using a laser having a necessary and sufficient output (30 mW or more), it is noted that a combination with the semiconductor laser single beam exposure device of the internal drum system is the most preferable taking into consideration the operability, costs and the like.

Also, for the purpose of increasing the rate of curing of the image recording layer during a period of time of from the image exposure with conventionally known active rays to the development, by providing a heating process at a temperature of from 50 °C to 150 °C for a time of from one second to 5 minutes, it is possible to enhance the curing property of a non-image portion, thereby further enhancing the printing resistance. Thus, such is more preferable.

Also, the developed photosensitive lithographic printing plate is subjected to a post treatment with washing water, a rinse liquid containing a surfactant, etc., or a desensitizing liquid containing gum arabic, a starch derivative, etc. as described in JP-A-54-8002, JP-A-55-115045, and JP-A-59-58431. Such a treatment can be employed in various combinations in the post treatment of the photosensitive lithographic plate of the invention. The lithographic printing plate obtained through such a treatment is applied to an offset printing machine and used for printing of a number of sheets.

Though it is possible to form an image by developing the foregoing photosensitive lithographic printing plate with a conventionally known developing solution, it is especially preferred to use the following special developing solution in view of image forming property and development scum. As the conventionally known developing solution, developing solutions described in JP-B-57-7427 are enumerated. Aqueous solutions of an inorganic alkaline agent (for example, sodium silicate, potassium silicate, sodium hydroxide, potassium hydroxide, lithium hydroxide, sodium triphosphate, sodium diphosphate, ammonium triphosphate, ammonium diphosphate, sodium metasilicate, sodium bicarbonate, and ammonia water) or an organic alkaline agent (for example, monoethanolamine and diethanolamine) are suitable. Such an alkaline solution is added in a concentration of from 0.1 to 10 % by weight, and preferably from 0.5 to 5 parts by weight.

Also, such an alkaline solution can be a small amount of a surfactant or an organic solvent such as benzyl alcohol, 2-phenoxyethanol, and 2-butoxyethanol as the need arises. For example, developing solutions described in U.S. Patent Nos. 3,375,171 and 3,615,480 can also be enumerated. Further, developing solutions described in JP-A-50-26601, JP-A-58-54341, JP-B-56-39464, and JP-B-56-42860 can be enumerated.

(Developing solution)

The developing solution which is used in the plate making method of the lithographic printing plate of the invention contains an inorganic alkaline salt and a polyoxyalkylene ether group-containing nonionic surfactant and has a pH of from 11.0 to 12.5.

The inorganic alkaline salt can be adequately used, and examples thereof include inorganic alkaline agents such as sodium hydroxide, potassium hydroxide, ammonium hydroxide, lithium hydroxide, sodium silicate, potassium silicate, ammonium silicate, lithium silicate, sodium triphosphate, potassium triphosphate, ammonium triphosphate, sodium carbonate, potassium carbonate, ammonium carbonate, sodium hydrogencarbonate, potassium hydrogencarbonate, ammonium hydrogencarbonate, sodium borate, potassium borate, and ammonium borate. These inorganic alkaline salts may be used singly or in combinations of two or more thereof.

In the case of using a silicate, the developability can be easily adjusted by adjusting a mixing ratio of silicon oxide $SiO_2$ to an alkaline oxide $M_2O$ (wherein M represents an alkali metal or an ammonium group) as components of the silicate and the concentration. With respect to the foregoing alkaline aqueous solution, the mixing ratio ($SiO_2/M_2O$ molar ratio) of the foregoing silicon oxide $SiO_2$ to the foregoing alkaline oxide $M_2O$ is preferably from 0.5 to 3.0, and more preferably from 1.0 to 2.0. When the foregoing $SiO_2/M_2O$ ratio is less than 0.5, the concentration of the silicate is preferably from 1 to 10 % by weight, more preferably from 3 to 8 % by weight, and most preferably from 4 to 7 % by weight based on the weight of the alkaline aqueous solution.

Also, for the purpose of minutely adjusting the alkaline concentration or assisting the solubility of the image recording layer, an organic alkaline agent may be supplementally used together. Examples of the organic alkaline agent include monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, and tetramethylammonium hydroxide. These alkaline agents are used singly or in combinations of two or more thereof.

It is essential that the developing solution to be used in the invention contains a polyoxyalkylene ether group-containing nonionic surfactant. By adding this surfactant, it becomes possible to accelerate dissolution of the image recording layer in an unexposed portion and to reduce penetration of the developing solution into an exposed portion. As the polyoxyalkylene ether group-containing nonionic surfactant, a material having a structure represented by the

following fomula (II) is suitably used.

$$R^{40}\text{-O- }(R^{41}\text{-O})_pH \quad \text{(II)}$$

In the formula, $R^{40}$ represents an optionally substituted alkyl group having from 3 to 15 carbon atoms, an optionally substituted aromatic hydrocarbon group having from 6 to 15 carbon atoms, or an optionally substituted heterocyclic aromatic ring group having from 4 to 15 carbon atoms (incidentally, examples of the substituent include an alkyl group having from 1 to 20 carbon atoms, a halogen atom (for example, Br, Cl, and I), an aromatic hydrocarbon group having from 6 to 15 carbon atoms, an aralkyl group having from 7 to 17 carbon atoms, an alkoxy group having from 1 to 20 carbon atoms, an alkoxycarbonyl group having from 2 to 20 carbon atoms, and an acyl group having from 2 to 15 carbon atoms); $R^{41}$ represents an optionally substituted alkylene group having from 1 to 100 carbon atoms (incidentally, examples of the substituent include an alkyl group having from 1 to 20 carbon atoms and an aromatic hydrocarbon group having from 6 to 15 carbon atoms); and p represents an integer of from 1 to 100.

In the foregoing definition of the formula (II) , specific examples of the "aromatic hydrocarbon group" include a phenyl group, a tolyl group, a naphthyl group, an anthryl group, a biphenyl group, and a phenanthryl group; and specific examples of the "heterocyclic aromatic ring group" include a furyl group, a thionyl group, an oxazolyl group, an imidazolyl group, a pyranyl group, a pyrimidinyl group, an acridinyl group, a benzofuranyl group, a benzothionyl group, a benzopyranyl group, a benzoxazolyl group, and a benzimidazolyl group.

Also, so far as the $(R^{41}\text{-O})_p$ moiety of the formula (II) falls within the foregoing range, it may be two or three kinds of groups. Specific examples include combinations of groups connecting to each other in the random or block state, such as a combination of an ethyleneoxy group and a propyleneoxy group, a combination of an ethyleneoxy group and an iso-propyloxy group, a combination of an ethyleneoxy group and a butyleneoxy group, a combination of an ethyleneoxy group and an isobutylene group. In the invention, the polyoxyalkylene ether group-containing surfactant is used singly or in a composite system, and it is effective that this surfactant is added in an amount of from 1 to 30 % by weight, and preferably from 2 to 20 % by weight in the developing solution. When the addition amount is too low, a lowering of the developability is observed. On the other hand, when the addition amount is too high, a damage of the development becomes strong, leading to a lowering of the printing resistance of the printing plate.

Also, examples of the polyoxyalkylene ether group-containing nonionic surfactant represented by the foregoing formula (II) include polyoxyethylene alkyl ethers such as polyoxyethylene lauryl ether, polyoxyethylene cetyl ether, and polyoxyethylene stearyl ether; polyoxyethylene aryl ethers such as polyoxyethylene phenyl ether and polyoxyethylene naphthyl ether; and polyoxyethylene alkylaryl ethers such as polyoxyethylene methylphenyl ether, polyoxyethylene octylphenyl ether, and polyoxyethylene nonylphenyl ether.

Further, other surfactants as described below may be added. Examples of other surfactants which can be used include nonionic surfactants such as polyoxyethylene alkyl esters (for example, polyoxyethylene stearate), sorbitan alkyl esters (for example, sorbitan monolaurate, sorbitan monostearate, sorbitan distearate, sorbitan monooleate, sorbitan sesquioleate, and sorbitan trioleate), and monoglyceride alkyl esters (for example, glycerol monostearate and glycerol monooleate); anionic surfactants such as alkylbenzenesulfonic acid salts (for example, sodium dodecylbenzenesulfonate), alkylnaphthalenesulfonic acid salts (for example, sodium butylnaphthalenesulfonate, sodium pentylnaphthalenesulfonate, sodium hexylnaphthalene-sulfonate, and sodium octylnaphthalenesulfonate), alkylsulfuric acid salts (for example, sodium laurylsulfate), alkylsulfonic acid salts (for example, sodium dodecylsulfonate), and sulfosuccinic ester salts (for example, sodium dilaurylsulfosuccinate); and ampholytic surfactants such as alkylbetains (for example, lauryl betain and stearyl betain) and amino acids. Of these, anionic surfactants such as alkylnaphthalenesulfonic acid salts are especially preferable.

These surfactants can be used singly or in combinations. Also, the content of the surfactant to be suitably used in the developing solution is in the range of from 0.1 to 20 % by weight as calculated in terms of the effective component.

The pH of the developing solution to be used in the invention is from 11.0 to 12.7, and preferably from 11.5 to 12.5. Also, it is preferable that the developing solution to be used in the invention has a conductivity of from 3 to 30 mS/cm, and especially preferably from 5 to 20 mS/cm.

The thus developed image recording material is subjected to a post treatment with washing water, a rinse liquid containing a surfactant, etc., or a desensitizing liquid containing gum arabic, a starch derivative, etc. as described in JP-A-54-8002, JP-A-55-115045, and JP-A-59-58431. Such a treatment can be employed in various combinations in the post treatment of the image recording material of the invention. In the printing plate obtaining through such a treatment, the printing resistance can be enhanced by a post exposure treatment by a method described in JP-A-2000-89478 or a heating treatment such as burning. The lithographic printing plate obtained through such a treatment is applied to an offset printing machine and used for printing of a number of sheets.

EXAMPLES

[Example 1]

The invention will be specifically described below with reference to the Examples, but it should not be construed that the invention is limited thereto. Incidentally, all percents and ratios are on a weight basis unless otherwise indicated.

[Examples 1 to 16 and Comparative Examples 1 to 6]

(Preparation method of aluminum support)

An aluminum plate having a thickness of 0.3 mm was etched by dipping in 10 % by weight sodium hydroxide at 60 °C for 25 seconds. Thereafter, the aluminum plate was washed with running water, neutralized and washed with 20 % by weight nitric acid, and then washed with water. The resulting aluminum plate was subjected to an electrolytic roughing treatment in a 1 % by weight nitric acid aqueous solution in a quantity of electricity at the time of anodization of 300 C/$dm^2$ using a sinusoidal alternating waveform current. Subsequently, the aluminum plate was dipped in a 1 % by weight sodium hydroxide aqueous solution at 40 °C for 5 seconds and then dipped in a 30 % by weight sulfuric acid aqueous solution at 60 °C for 40 seconds to achieve desmutting. Thereafter, the resulting aluminum plate was subjected to an anodic oxidation treatment in a 20 % by weight sulfuric acid aqueous solution in a current density of 2 A/$dm^2$ for 2 minutes such that the anodically oxidized film had a thickness of 2.7 g/$m^2$. The surface roughness was measured and found to be 0.3 μm (in terms of Ra according to JIS B0601).

[Provision of interlayer]

Next, a coating solution for interlayer having the following formulation was coated on the aluminum support using a wire bar and dried at 90 °C for 30 seconds using a hot air type drying device. The coating amount after drying was 10 mg/$m^2$.

(Coating solution for interlayer)

| | |
|---|---|
| Copolymer of ethyl methacrylate and sodium<br>2-acrylamido-2-methyl-1-propanesulfonate (molar ratio: 75/25) (molecular weight: 18,000)<br>2-Aminoethylphosphonic acid | 0.1 g<br>0.1 g |
| Methanol | 50 g |
| Ion-exchanged water | 50 g |

[Provision of image recording layer]

A coating solution for photosensitive layer having the following formulation was prepared and coated on the foregoing interlayer in a thickness after drying of 0.15 g/$m^2$ using a wheeler, followed by drying at 100 °C for one minute.

(Coating solution for photosensitive layer)

| | |
|---|---|
| Ethylenically unsaturated compound: pentaerythritol tetraacrylate | 1.5 g |
| Binder: one having the following structure | 1.8 g |

Binder

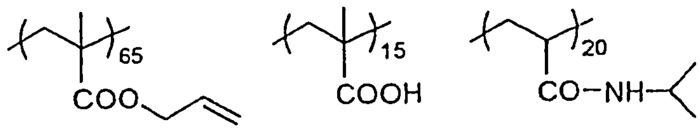

Mw: 150,000

| | |
|---|---|
| Sensitizing dye: compound shown in Table 1 | 0.1 g |
| Titanocene compound: one having the following structure | 0.2 g |

Titanocene compound

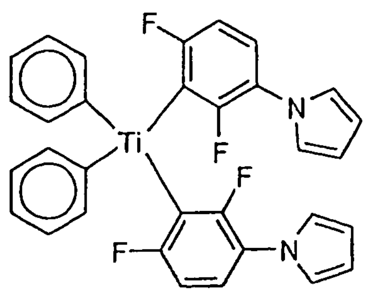

Halomethyl triazine compound: compound shown Shown in Table 1 in Table 1

| | |
|---|---|
| Coloring pigment dispersion: one having the following formulation | 2.0 g |
| Heat polymerization inhibitor: N-nitrosophenylhydroxylamine aluminum salt | 0.01 g |
| Surfactant: Megaface F176, manufactured by Dainippon Ink and Chemicals, Incorporated | 0.02 g |
| Methyl ethyl ketone | 20.0 g |
| Propylene glycol monomethyl ether | 20.0 g |

<Formulation of pigment dispersion>

| | |
|---|---|
| Pigment Blue 15:6 | 15 parts by weight |
| Ally methacrylate/methacrylic acid copolymer (copolymerization molar ratio: 83/17) as heat polymerized | 10 parts by weight |
| Cyclohexanone | 15 parts by weight |
| Methoxypropyl acetate | 20 parts by weight |
| Propylene glycol monomethyl ether | 40 parts by weight |

[Provision of protective layer]

A coating solution for protective layer having the following formulation was coated on this image recording layer in a coating weight after drying of 2 $g/m^2$ and dried at 100 °C for 2 minutes.

<Formulation of coating solution for protective layer>

| | |
|---|---|
| Polyvinyl alcohol (degree of hydrolysis: 98 % by mole, degree of polymerization: 550) | 4 g |
| Polyvinylpyrrolidone (molecular weight: 100,000) | 1 g |
| Water | 95 g |

The resulting photosensitive lithographic printing plate was subjected to plate making in the following manner and evaluated with respect to the sensitivity and printing resistance.

(Exposure)

In Examples 1 to 8 and Comparative Examples 1 to 3, the quantity of light was adjusted using an internal drum type laboratory machine mounted with a 100-mW FD-YAG laser (532 nm) in such a manner that the quantity of light on the plate surface became 0.2 mJ/cm$^2$, and a gray scale was stuck onto the plate surface, followed by exposure from the upper side. The gray scale was prepared in such a manner that the quantity of light was changed every $1/\sqrt{2}$, and as the number of steps of the gray scale increases, the sensitivity becomes high.
In Examples 9 to 16 and Comparative Examples 4 to 6, the quantity of light was adjusted using an internal drum type laboratory machine mounted with a 30-mW violet laser (405 nm) in such a manner that the quantity of light on the plate surface became 0.1 mJ/cm$^2$, followed by exposure in the same manner. (Development/plate making)
An automatic processor LP-850P2, manufactured by Fuji Photo Film Co., Ltd. (preheating temperature: 100 °C) was charged with the following developing solution and a finisher FP-2W, manufactured by Fuji Photo Film Co., Ltd., respectively, and the exposed plate was subjected to development/plate making under conditions at a developing solution temperature of 30 °C for a development time of 18 seconds, to obtain a lithographic printing plate.

(Aqueous solution having the following formulation and having a pH of 11.6)

| | |
|---|---|
| Sodium hydroxide | 0.15 parts by weight |
| Compound having the following structure | 5.0 parts by weight |
| Tetrasodium ethylenediaminetetraacetate | 0.1 parts by weight |
| Water | 94.75 parts by weight |

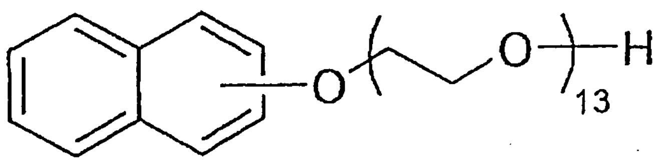

The measurement of sensitivity was carried out under the foregoing conditions.
With respect to the printing resistance, the number of sheets at which a solid image prepared under the foregoing conditions was abraded in the printing step so that an ink no longer attached thereto was examined. A used printing machine was an R201 Model printing machine, manufactured by MAN Roland, and GEOS-G Black (N), manufactured by Dainippon Ink and Chemicals, Incorporated was used as the ink.
The evaluation results are shown in Table 1.

Table 1

| Example | Sensitizing dye | Halomethyl triazine Compound | Amount (g) | Sensitivity (G/S the number of steps) | Printing resistance, (× 10,000 sheets) |
|---|---|---|---|---|---|
| 1 | 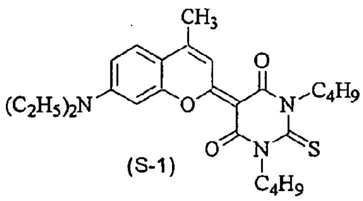 (S-1) | (I)-1 | 0.05 | 5.5 | 10 |
| 2 | | (I)-5 | 0.05 | 5.5 | 10 |
| 3 | | (I)-5 | 0.1 | 5.75 | 9 |
| 4 | | (I)-6 | 0.05 | 5.5 | 12 |
| 5 | | (I)-11 | 0.05 | 5.0 | 12 |
| 6 | | (I)-12 | 0.05 | 5.0 | 9 |
| 7 | | (I)-14 | 0.05 | 5.5 | 9 |
| 8 | | (I)-15 | 0.05 | 5.5 | 9 |
| 9 | 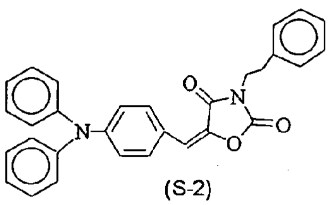 (S-2) | (I)-1 | 0.05 | 5.25 | 10 |
| 10 | | (I)-1 | 0.025 | 5.25 | 9 |
| 11 | | (I)-2 | 0.05 | 5.5 | 10 |
| 12 | | (I)-5 | 0.05 | 5.25 | 9 |
| 13 | | (I)-7 | 0.05 | 5.25 | 11 |
| 14 | | (I)-8 | 0.05 | 5.0 | 10 |
| 15 | | (I)-15 | 0.05 | 5.25 | 9 |
| 16 | | (I)-18 | 0.05 | 5.25 | 9 |
| Comparative Example | | | | | |
| 1 | S-1 | Nothing | | 4.25 | 6 |
| 2 | | 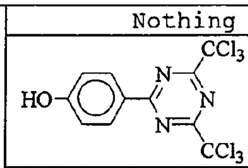 | 0.05 | 4.0 | 4 |
| 3 | | 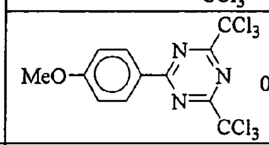 | 0.05 | 4.25 | 6 |
| 4 | S-2 | Nothing | | 4.0 | 6 |
| 5 | | 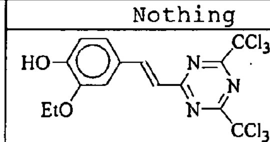 | 0.05 | 4.25 | 4 |
| 6 | | 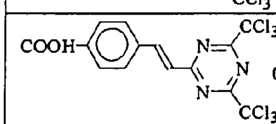 | 0.05 | 4.25 | 2 |

It has become clear from Table 1 that according to the invention, high sensitivity and high printing resistance are obtained as compared with the Comparative Examples.

[Examples 17 to 32 and Comparative Examples 7 to 12]

(Preparation method of aluminum support)

An aluminum plate having a thickness of 0 . 30 mm and having a material quality of 1S was subjected to sand blasting on the surface using a No. 8 nylon brush and an aqueous suspension of 800-mesh pumistone and then well

washed with water. The aluminum plate was etched by dipping in 10 % sodium hydroxide at 70 °C for 60 seconds, washed with running water, neutralized and washed with 20 % $HNO_3$, and then washed with water. The resulting aluminum plate was subjected to an electrolytic roughing treatment in a 1 % by weight nitric acid aqueous solution in a quantity of electricity at the time of anodization of 300 C/dm$^2$ under a condition of $V_A$ = 12. 7 V using a sinusoidal alternating waveform current. The surface roughness was measured and found to be 0.45 μm (in terms of Ra). Subsequently, the aluminum plate was dipped in a 30 % $H_2SO_4$ aqueous solution at 55 °C for 2 minutes to achieve desmutting. Thereafter, the resulting aluminum plate was subjected to anodic oxidation in a 20 % $H_2SO_4$ aqueous solution at 33 °C in a current density of 5 A/dm$^2$ for 50 seconds while aligning a cathode on the sand blasted surface. As a result, the thickness was 2.7 g/m$^2$.

[Provision of interlayer]

Next, a coating solution for interlayer having the following formulation was coated on the aluminum support using a wire bar and dried at 90 °C for 30 seconds using a hot air type drying device. The coating amount after drying was 10 mg/m$^2$.

(Coating solution for interlayer)

| | |
|---|---|
| Methanol | 90 g |
| Pure water | 10 g |
| Compound having the following structure | 0.01 g |

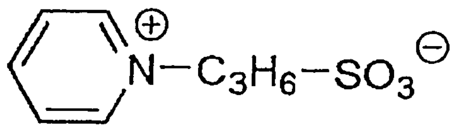

[Provision of image recording layer]

A coating solution for photosensitive layer having the following formulation was prepared and coated on the foregoing interlayer in a thickness after drying of 0.15 g/m$^2$ using a wheeler, followed by drying at 120 °C for 2 minutes.

(Coating solution for photosensitive layer (photopolymerizable composition): shown in detail in Table 2)

| | |
|---|---|
| Ethylenically unsaturated bond-containing compound (having the following structure) | 2.0 g |

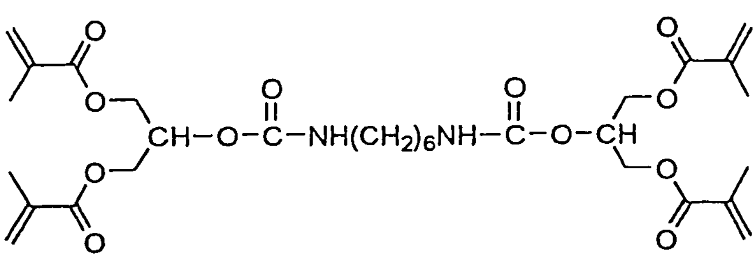

| | |
|---|---|
| Binder: urethane resin (having the following structure) | 1.5 g |

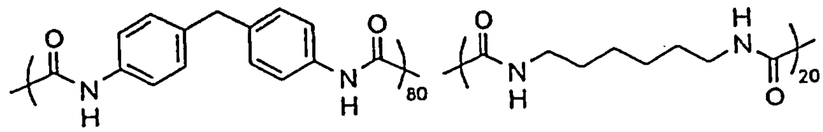

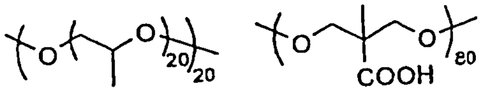

| | |
|---|---|
| Sensitizing dye: compound shown in Table 1 | 0.1 g |
| Titanocene compound (having the following structure) | 0.2 g |

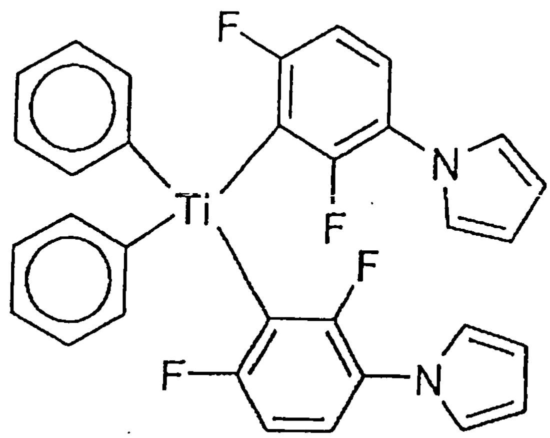

Halomethyl triazine compound: compound shown Shown in Table 2 in Table 2

| | |
|---|---|
| Coloring pigment dispersion: one having the following formulation | 2.0 g |
| Heat polymerization inhibitor: p-methoxyphenol | 0.01 g |
| Surfactant: Megaface F176 | 0.02 g |
| Methyl ethyl ketone | 20.0 g |
| Propylene glycol monomethyl ether | 20.0 g |

[Provision of protective layer]

A coating solution for protective layer having the following formulation was coated on this image recording layer in a coating weight after drying of 2.5 g/$m^2$ and dried at 100 °C for 2 minutes.

<Formulation of coating solution for protective layer>

| | |
|---|---|
| Polyvinyl alcohol (degree of hydrolysis: 95 % by mole, degree of polymerization: 800) | 4 g |
| Polyvinylpyrrolidone (molecular weight: 50,000) | 0.5 g |
| Poly(vinylpyrrolidone/vinyl acetate (1/1)), molecular weight: 70,000 | 0.5 g |
| Water | 95 g |

The resulting photosensitive lithographic printing plate was subjected to plate making in the following manner

and evaluated with respect to the sensitivity and printing resistance.

(Exposure)

In Examples 17 to 24 and Comparative Examples 7 to 9, the quantity of light was adjusted using an internal drum type laboratory machine mounted with a 100-mW FD-YAG laser (532 nm) in such a manner that the quantity of light on the plate surface became 0.2 mJ/cm$^2$, and a gray scale was stuck onto the plate surface, followed by exposure from the upper side. The gray scale was prepared in such a manner that the quantity of light was changed every $1/\sqrt{2}$, and as the number of steps of the gray scale increases, the sensitivity becomes high.

In Examples 25 to 32 and Comparative Examples 10 to 12, the quantity of light was adjusted using an internal drum type laboratory machine mounted with a 30-mW violet laser (405 nm) in such a manner that the quantity of light on the plate surface became 0.1 mJ/cm$^2$, followed by exposure in the same manner.

The exposed plate was subjected to development/plate making using the same developing solution and under the same development conditions as in Examples 1 to 16 and Comparative Examples 1 to 6, to obtain a lithographic printing plate.

The measurement of sensitivity was carried out under the foregoing conditions.

With respect to the printing resistance, the number of sheets at which a solid image prepared under the foregoing conditions was abraded in the printing step so that an ink no longer attached thereto was examined. A used printing machine was an R201 Model printing machine, manufactured by MAN Roland, and GEOS-G Black (N), manufactured by Dainippon Ink and Chemicals, Incorporated was used as the ink.

The evaluation results are shown in Table 2.

Table 2

| Example | Sensitizing dye | Halomethyl triazine Compound | Amount(g) | Sensitivity (G/S the number of steps) | Printing resistance, (x 10,000 sheets) |
|---|---|---|---|---|---|
| 17 | S-1 of Table 1 | (I)-1 | 0.1 | 5.25 | 12 |
| 18 | | (I)-1 | 0.05 | 5.25 | 12 |
| 19 | | (I)-5 | 0.1 | 5.25 | 15 |
| 20 | | (I)-3 | 0.1 | 5.5 | 15 |
| 21 | | (I)-4 | 0.1 | 5.25 | 12 |
| 22 | | (I)-9 | 0.1 | 5.0 | 14 |
| 23 | | (I)-10 | 0.1 | 5.0 | 13 |
| 24 | | (I)-13 | 0.1 | 5.25 | 12 |
| 25 | S-2/S-3 = 1/4 of Table 1 | (I)-1 | 0.1 | 5.25 | 15 |
| 26 | 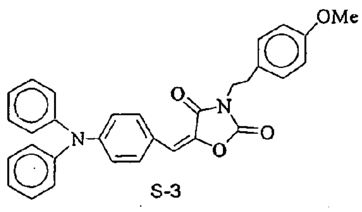 S-3 | (I)-5 | 0.05 | 5.0 | 12 |
| 27 | | (I)-5 | 0.1 | 5.25 | 13 |
| 28 | | (I)-4 | 0.1 | 5.25 | 14 |
| 29 | | (I)-7 | 0.1 | 5.0 | 12 |
| 30 | | (I)-8 | 0.1 | 5.0 | 12 |
| 31 | | (I)-16 | 0.1 | 5.0 | 15 |
| 32 | | (I)-17 | 0.1 | 5.0 | 12 |
| Comparative Example | | | | | |
| 7 | S-1 | Nothing | | 3.75 | 8 |
| 8 | | 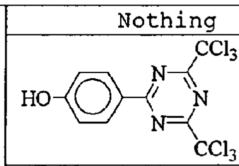 | 0.1 | 3.5 | 4 |
| 9 | | 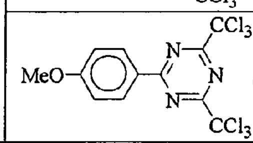 | 0.1 | 4.0 | 6 |
| 10 | S-2/S-3=1/4 | Nothing | | 3.5 | 8 |
| 11 | | 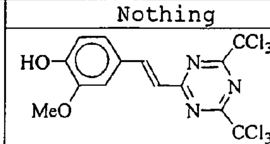 | 0.1 | 3.75 | 7 |
| 12 | | 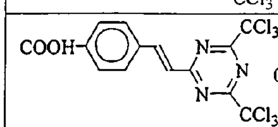 | 0.1 | 3.75 | 6 |

It has become clear from Table 2 that according to the invention, high sensitivity and high printing resistance are obtained as compared with the Comparative Examples.

[Example 2]

[Examples 1 to 19 and Comparative Examples 1 to 6]

[Preparation of polymerizable photosensitive printing plate]

An aluminum plate having a thickness of 0.30 mm and having a material quality of 1S was subjected to sand

blasting on the surface using a No. 8 nylon brush and an aqueous suspension of 800-mesh pumistone and then well washed with water. The aluminum plate was etched by dipping in 10 % sodium hydroxide at 70 °C for 60 seconds, washed with running water, neutralized and washed with 20 % $HNO_3$, and then washed with water. The resulting aluminum plate was subjected to an electrolytic roughing treatment in a 1 % by weight nitric acid aqueous solution in a quantity of electricity at the time of anodization of 300 C/dm$^2$ under a condition of $V_A$ = 12.7 V using a sinusoidal alternating waveform current. The surface roughness was measured and found to be 0.45 μm (in terms of Ra). Subsequently, the aluminum plate was dipped in a 30 % $H_2SO_4$ aqueous solution at 55 °C for 2 minutes to achieve desmutting. Thereafter, the resulting aluminum plate was subjected to anodic oxidation in a 20 % $H_2SO_4$ aqueous solution at 33 °C in a current density of 5 A/dm$^2$ for 50 seconds while aligning a cathode on the sand blasted surface. As a result, the thickness was 2.7 g/m$^2$.

An undercoating layer was provided on the thus treated aluminum plate in the following procedures.

The following liquid composition for undercoating was mixed and stirred at 30°C. Approximately 5 minutes later, heat generation was observed, and reaction was continued for 60 minutes. The contents were then moved into another container, and 30,000 parts by weight of methanol was added thereto to prepare a liquid coating solution.

(Liquid composition for undercoating)

| | |
|---|---|
| Compound described below | 50 parts by weight |
| Methanol | 130 parts by weight |
| Water | 20 parts by weight |
| p-Toluenesulfonic acid | 5 parts by weight |
| Tetraethoxysilane | 50 parts by weight |
| 3-Methacryloxypropyltrimethoxysilane | 50 parts by weight |

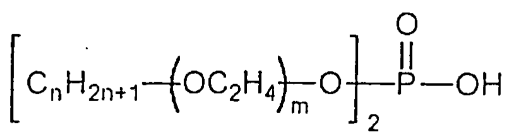

Nn ≅ 10 to 15, m ≅ 6 to 10

This liquid coating solution was coated on the foregoing treated aluminum plate in a coating amount of 0.1 g/m$^2$ and dried at 100 °C for one minute.

A polymerizable photosensitive composition 1 having the following formulation was coated on the thus obtained undercoating layer in a coating weight after drying of 1. 4 g/m$^2$ and dried at 120 °C for 90 seconds to form an image recording layer.

(Polymerizable photosensitive composition 1)

| | |
|---|---|
| Ethylenically unsaturated double bond-containing monomer (A1 described below) | 0.54 parts by weight |
| Binder (B1, Mw = 70,000)<br>MDI/HMDI/DMPA/TEG/PPG1000 =<br>40/10/26/13/11 (molar ratio) | 0.46 parts by weight |
| Dye (S1 described below) | 0.0074 parts by weight |
| Dye (S2 described below) | 0.023 parts by weight |
| Polymerization initiator (D1 described below) | 0.10 parts by weight |
| Sensitization auxiliary (E1 described below) | 0.15 parts by weight |
| Trihalomethyl initiator (see Table 3) | 1 %: 0.0138 parts by weight<br>3 %: 0.0414 parts by weight |
| Coloring agent | |

(continued)

| | |
|---|---|
| Dispersion of ε-phthalocyanine (F1 described below), allyl methacrylate/methacrylic acid (80/20, Mw = 50,000) and propylene glycol monomethyl acetate (15/10/75) | 0.40 parts by weight |
| Fluorine based nonionic surfactant, Megaface F780F (30 % MEK solution, manufactured by Dainippon Ink and Chemicals, Incorporated) | 0.006 parts by weight |
| Polymerization inhibitor: cupferron AL/tricresyl phosphate (10/90) | 0.016 parts by weight |
| Methyl ethyl ketone | 6.0 parts by weight |
| Propylene glycol monomethyl ether acetate | 5.0 parts by weight |

S 1

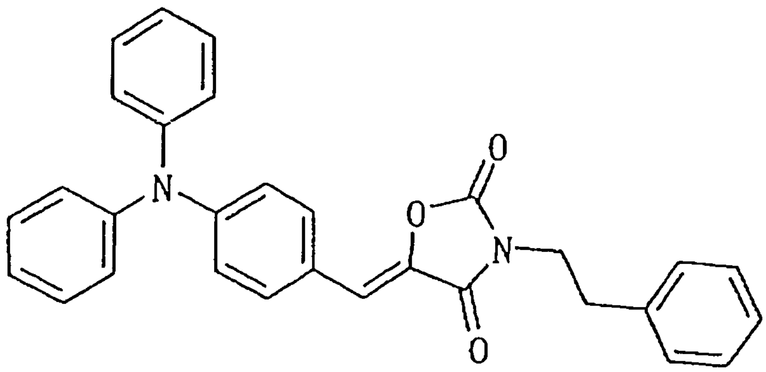

S 2

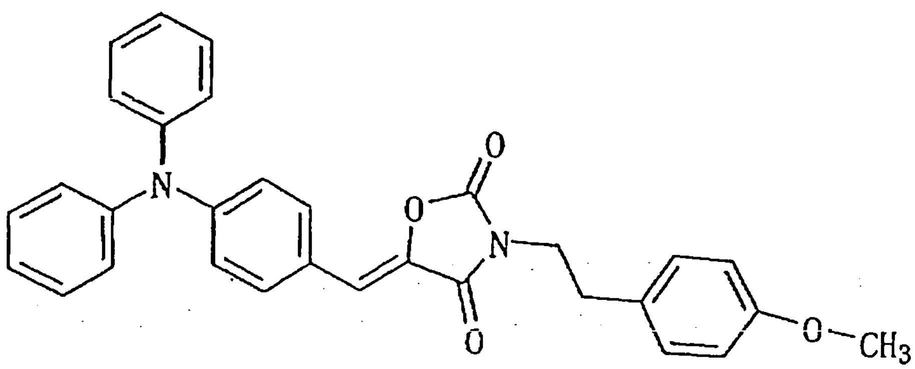

A-1

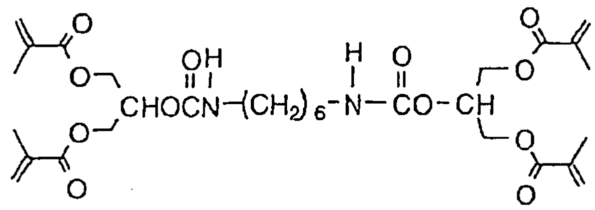

D1

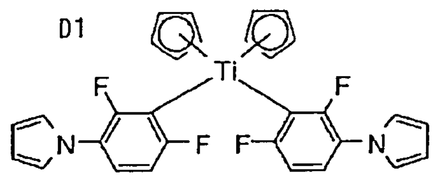

E1

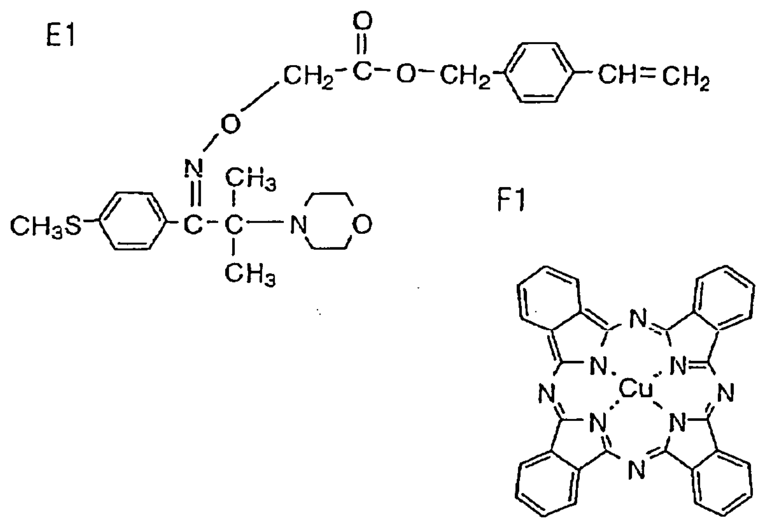

F1

B1

MDI

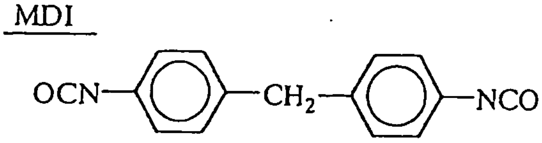

HMDI

$OCN-(CH_2)_6-NCO$

DMPA

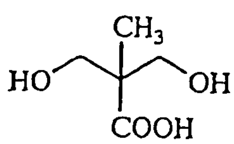

TEG

$HO-(C_2H_4O)_4-H$

PPG1000

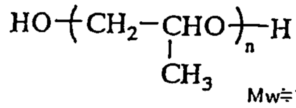

Mw≒1000

A 6 % aqueous solution made of the following materials was coated as an oxygen-shielding protective layer on this image recording layer in a coating weight after drying of 2.5 g/$m^2$ and dried at 100 °C for 90 seconds to obtain an image recording material.

(Composition for oxygen-shielding protective layer)

| | |
|---|---|
| Polyvinyl alcohol (PVA-105, manufactured by Kuraray Co., Ltd., degree of hydrolysis: 98 % by mole, degree of polymerization: 500) | 2.2 parts by weight |
| Polyvinylpyrrolidone (K30, manufacture by Wako Pure Chemical Industries, Ltd.) | 0.12 parts by weight |
| Luvitec VA64W (manufactured by BASF) | 0.073 parts by weight |
| EMALEX 710 (surfactant, manufactured by Nihon-Emulsion Co., Ltd.) | 0.043 parts by weight |

The thus obtained image recording material of 40 x 60 cm was set in Luxel Plate Setter Vx-9600 CTP (manufactured by Fuji Photo Film Co., Ltd.) mounted with a violet laser (405 nm).

A host computer system gave instructions so as to treat a newspaper space.

The image recording material was image exposed under conditions of 50 μJ/$cm^2$, 1,000 dpi and 100 lpi. The exposed recording material was post heated using an automatic processor FLP 125NFS, manufactured by Fuji Photo Film Co., Ltd. in such a manner that the surface temperature was 115 °C in the central portion of the plate back surface in the pre-heating section, and the oxygen-shielding protective layer was washed out with water at 23 °C in a preliminary water wash tank.

Thereafter, the resulting image recording material was developed at 25 °C for 20 seconds using a mixture of a developing solution DV-2, manufactured by Fuji Photo Film Co., Ltd. and water (1/4) in a development tank. Thereafter, the developed image recording material was washed with water in a water wash tank, subjected to a standard treatment with a mixture of a finishing gum FP-2W, manufactured by Fuji Photo Film-Co., Ltd. and water (1/1) in a gum tank, and then dried using warm air at 50 °C in a heating section. At that time, the coating amount of the gum was 150 mg/$m^2$ in terms of a dry weight.

Table 3 shows a molar extinction coefficient ε and a molecular weight Mw of the trihalomethyl initiator used in each of the Examples and Comparative Examples at 405 nm, an absorptivity of the trihalomethyl initiator of the coating solution at 405 nm, G/S sensitivity, and printing resistance.

[Molar extinction coefficient ε]

The trihalomethyl initiator was preciously weighed in an amount of from about 50 to 500 mg on an aluminum foil of about 3 × 3 cm. The entirety of the aluminum foil was placed in a 100-mL measuring flask, THF was added to make it to 100 mL, and the mixture was dissolved for 10 minutes in an ultrasonic washer. 10 mL of the solution was taken by a 10-mL whole pipette and further diluted to 1/10 with THF in a 100-mL measuring flask. The resulting solution was measured by a UV photometer U-3000, manufactured by Hitachi, Ltd. using a 1-cm quartz cell while using THF as a reference.

[Absorptivity at 405 nm]

The photosensitive solution was taken by a 10-mL whole pipette and diluted to 1/10 with MEK in a 100-mL measuring flask. Further, 5 mL of this solution was taken and diluted to 1/20 in a 100-mL measuring flask. The absorptivity of the trihalomethyl initiator was determined from an absorbance at 405 nm of the photosensitive solution to which the trihalomethyl initiator had not been added and an absorbance at 405 nm of the photosensitive solution to which the trihalomethyl initiator had been added.

[G/S sensitivity]

Gray Scale Step Guide P, manufactured by Fuji Photo Film Co., Ltd. was stuck onto the photosensitive material using an adhesive tape and subjected to solid exposure from the upper side. Thereafter, the photosensitive material was developed under the foregoing conditions and evaluated. The photosensitive material to which the trihalomethyl initiator had not been added exhibited 5.0 steps, and Table 3 shows differences from this value.

[Evaluation of image recording material]

[Printing resistance]

The foregoing image recording material having been subjected to exposure and development in each of the Examples and Comparative Examples was subjected to plate making by continuous printing using a printing machine, four-color tower type rotary press CT7000, manufactured by Tokyo Kikai Seisakusho, Ltd., an ink for newspaper manufactured by Toyo Ink Mfg Co., Ltd. as an ink, News King Alke for newspaper (pH = 10.2) manufactured by Toyo Ink Mfg Co., Ltd. as dampening water, paper (44 g/$m^2$) manufactured by Oji Paper Co., Ltd., Tomakomai, and MP-75R (2.07 mm), manufactured by Kiyosha Co., Ltd. as a blanket. In this regard, how many sheets could be printed while keeping a sufficient ink density was visually measured, thereby evaluating the printing resistance. It is to be evaluated that the larger the number of sheets, the more excellent the printing resistance is. The results are shown in Table 3.

Table 3: Examples and Comparative Examples

| | Trihalomethyl initiator | | | Absorptivity at 405 nm (%) | | Relative G/S sensitivity | | Printing resistance | |
|---|---|---|---|---|---|---|---|---|---|
| | | ε at 405 nm | Mw | 1 wt% | 3 wt % | 1 wt% | 3 wt% | 1 wt% | 3 wt% |
| Example 1 | Compound 1-1 | 0 | 460 | 0.0 | 0.0 | 1.0 | 1.0 | 250,000 | 250.000 |
| Example 2 | Compound 1-2 | 0 | 471 | 0.0 | 0.0 | 1.0 | 1.0 | 250,000 | 250.000 |
| Example 3 | Compound 1-3 | 0 | 392 | 0.0 | 0.0 | 1.0 | 1.0 | 250,000 | 250.000 |
| Example 4 | Compound 1-4 | 0 | 426 | 0.0 | 0.0 | 1.0 | 1.0 | 250,000 | 250.000 |
| Example 5 | Compound 1-5 | 100 | 422 | 0.1 | 0.3 | 1.0 | 1.0 | 250,000 | 250.000 |
| Example 6 | Compound 1-6 | 240 | 527 | 0.2 | 0.6 | 1.0 | 1.0 | 250,000 | 250.000 |
| Example 7 | Compound 1-7 | 530 | 436 | 0.6 | 1.7 | 1.2 | 1.2 | 270,000 | 270,000 |
| Example 8 | Compound 1-8 | 760 | 534 | 0.7 | 2.0 | 1.0 | 1.0 | 250,000 | 250.000 |
| Comparative Example 1 | Compound A | 9,120 | 494 | 8.5 | 25.5 | 0.0 | -0.5 | 200,000 | 150,000 |
| Comparative Example 2 | Compound B | 9,200 | 658 | 6.4 | 19.3 | 0.0 | -0.3 | 200,000 | 170,000 |
| Comparative Example 3 | Compound C | 9,300 | 472 | 9.1 | 27.2 | 0.0 | -0.5 | 200,000 | 150,000 |
| Comparative Example 4 | Compound D | 20,000 | 448 | 20.5 | 61.6 | -0.3 | -2.5 | 170,000 | 20,000 |
| Comparative Example 5 | Compound E | 24,800 | 579 | 19.7 | 59.1 | -0.3 | -2.0 | 170,000 | 50,000 |
| Example 9 | Compound 2-1 | 0 | 290 | 0.0 | 0.0 | 0.5 | 0.5 | 220,000 | 220,000 |
| Example 10 | Compound 2-2 | 50 | 320 | 0.1 | 0.2 | 0.5 | 0.5 | 220,000 | 220,000 |
| Example 11 | Compound 2-3 | 100 | 334 | 0.1 | 0.4 | 0.5 | 0.5 | 220,000 | 220,000 |
| Example 12 | Compound 2-4 | 0 | 324 | 0.0 | 0.0 | 0.5 | 0.5 | 220,000 | 220,000 |
| Example 13 | Compound 2-5 | 0 | 315 | 0.0 | 0.0 | 0.5 | 0.5 | 220,000 | 220,000 |
| Example 14 | Compound 2-6 | 20 | 270 | 0.0 | 0.1 | 0.5 | 0.5 | 220,000 | 220,000 |
| Example 15 | Compound 2-7 | 50 | 453 | 0.1 | 0.2 | 0.5 | 0.5 | 220,000 | 220,000 |

| | Trihalomethyl initiator | | | Absorptivity at 405 nm (%) | | Relative G/S sensitivity | | Printing resistance | |
|---|---|---|---|---|---|---|---|---|---|
| | | ε at 405 nm | Mw | 1 wt% | 3 wt % | 1 wt% | 3 wt% | 1 wt% | 3 wt% |
| Comparative Example 6 | Compound F | 5,500 | 392 | 6.5 | 19.4 | -0.3 | -0.5 | 170,000 | 150,000 |
| Example 16 | Compound 3-1 | 0 | 575 | 0.0 | 0.0 | 0.5 | 0.5 | 220,000 | 220,000 |
| Example 17 | Compound 3-2 | 0 | 443 | 0.0 | 0.0 | 0.5 | 0.5 | 220,000 | 220,000 |
| Example 18 | Compound 3-3 | 0 | 393 | 0.0 | 0.0 | 0.5 | 0.5 | 220,000 | 220,000 |
| Example 19 | Compound 3-4 | 0 | 492 | 0.0 | 0.0 | 0.5 | 0.5 | 220,000 | 220,000 |
| | Not added | | | | | 0.0 | | 200,000 | |

comparative compound A

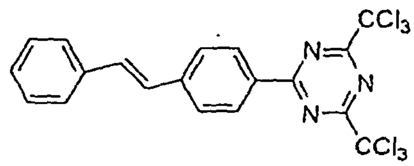

λ max=368nm
λ max ε =41、900
405nm ε =9. 120
Mw=494

comparative compound B

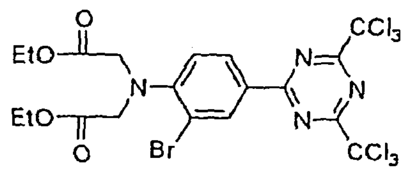

λ max=372nm
λ max ε =24、800
405nm ε =9、200
Mw=658

comparative compound C

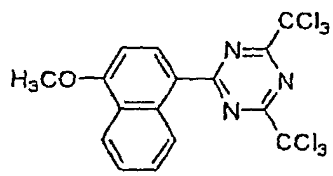

λ max=386nm
λ max ε =20、050
405nm ε =9、300
Mw=472

comparative compound D

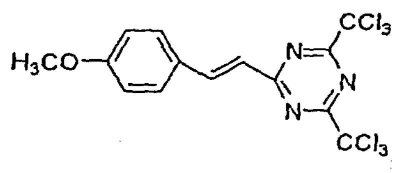

λ max=377nm
λ max ε =35、700
405nm ε =20、000
Mw=448

comparative compound E

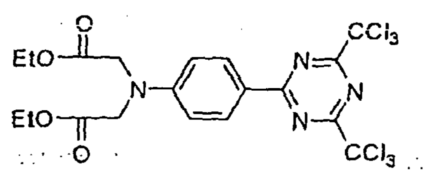

λ max=386nm
λ max ε =37、000
405nm ε =24、800
Mw=579

comparative compouud F

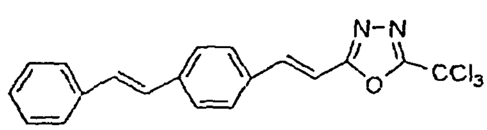

λ max=365nm
λ max ε =54、100
405nm ε =5, 500
Mw=392

As is clear from the foregoing results, it is noted that the image recording material of each of the Examples according to the invention has high sensitivity and excellent printing resistance.

The present invention is not limited to the specific above-described embodiments. It is contemplated that numerous modifications may be made to the present invention without departing from the spirit and scope of the invention as defined in the following claims.

This application is based on Japanese Patent application JP 2003-304490, filed August 28, 2003, and JP 2003-331593, filed September 24, 2003, the entire content of which are hereby incorporated by reference.

**Claims**

1. A photopolymerizable composition comprising:

(A) addition polymerizable compound having an ethylenically unsaturated double bond;
(B) one of an alkali-soluble binder and an alkali swelling binder,
(C) a titanocene compound, and
(D) a triazine compound represented by the following fomula (I):

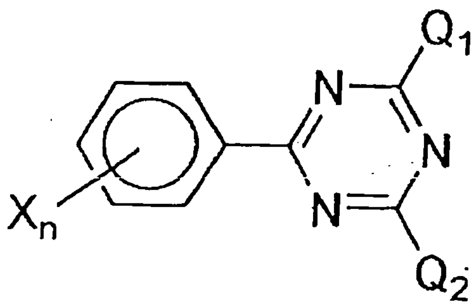

(I)

wherein $Q_1$ and $Q_2$ each independently represents a halomethyl group; X represents an electron withdrawing substituent having a Hammett's σ value of from 0 to +0.8, exclusive of a COOH group; and n represents an integer of from 0 to 5.

2. A photopolymerizable composition comprising:

(A) addition polymerizable compound having an ethylenically unsaturated double bond;
(B) one of an aqueous alkali-soluble binder and a alkali swelling binder,
(C) a titanocene compound, and
(D2) a compound containing a trihalomethyl group having a molar extinction coefficient of not more than 1,000 at a wavelength of laser to be exposed.

3. The photopolymerizable composition according to claim 2, wherein the compound (D2) is a compound represented by any one of the following fomulae (1) to (3):

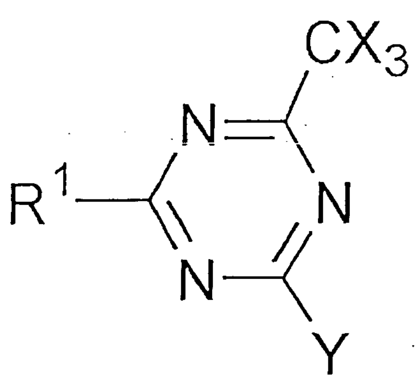

(1)

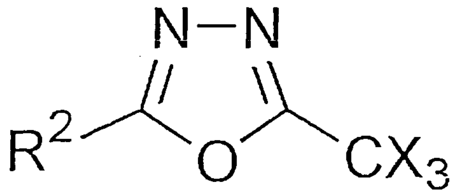

(2)

$$R^3\text{-}CX_3 \qquad (3)$$

wherein X represents a halogen atom; Y represents $-CX_3$, $-NH_2$, - NHR, $-NR_2$, or -OR; R and $R^1$ each independently represents $-CX_3$, an alkyl group, an aryl group, an alkenyl group, or a heterocyclic group; $R^2$ represents an alkyl group, an aryl group, an alkenyl group, or a heterocyclic group; and $R^3$ represents $R\text{-}SO_2\text{-}$, an alkyl group, an aryl group, an alkenyl group, or a heterocyclic group.

**4.** The photopolymerizable composition according to claim 1, which further comprising (E) a sensitizing dye.

**5.** The photopolymerizable composition according to claim 4, wherein the sensitizing dye (E) has an absorption maximum wavelength at a range of from 330 to 430 nm.

**6.** The photopolymerizable composition according to claim 1, wherein the binder (B) is one of a (meth)acrylic binder and a polyurethane based binder.

**7.** An image recording material comprising a support and an image recording layer on the support, wherein the image recording material comprises the photopolymerizable composition according to claim 1.